# EUROPEAN PATENT SPECIFICATION

(11) **EP 1 953 818 B1**
(45) Date of publication and mention of the grant of the patent: **04.01.2012**
(21) Application number: 06823492.1
(22) Date of filing: 22.11.2006
(51) Int. Cl.: H05K 1/02, H01L 23/12, H01L 23/36, H01L 33/00, H05K 3/24

(54) **ELECTRONIC COMPONENT MOUNTING BOARD**
PLATTE ZUR ANBRINGUNG ELEKTRONISCHER KOMPONENTEN
CARTE DE MONTAGE DE COMPOSANTS ELECTRONIQUES

(30) Priority: 24.11.2005 JP 2005339055
(43) Date of publication of application: 06.08.2008
(73) Proprietor: Sanyo Electric Co., Ltd., Osaka 570-8677 (JP); Matsuoka, Yoichi, Izumi-Shi, Osaka 594-0041 (JP)
(72) Inventor: MATSUOKA, Yoichi, Izumi-Shi Osaka 594-0041 (JP); YANASE, Naoya, Sakai-Shi Osaka 593-8301 (JP)
(74) Representative: Glawe, Delfs, Moll
(86) International application number: PCT/JP2006/323265
(87) International publication number: WO 2007/060966

(56) References cited:
- WO-A1-2004/084319
- WO-A1-2004/084319
- WO-A1-2005/083807
- JP-A- 2004 031 744
- JP-A- 2005 039 100
- US-A1- 2004 041 222
- US-A1- 2004 223 327
- US-A1- 2004 264 141

## Description

### Technical Field

The present invention relates to an electronic component mounting board, and to a method of fabricating such a board; more specifically, the invention relates to an electronic component mounting board suitable for a surface-mounting LED, and to a method of fabricating such a board.

### Background Art

In a known electronic component mounting board (see, for example, Patent Document 1 listed below), as shown in Figs. 20A to 20C, a metal frame 107 formed from a metal block and having leg portions 137 is fitted, with an adhesive layer 108, on a circuit board 106 having, formed on the top surface of an insulating base member 101 formed of a resin laminate or the like, a plurality of obverse-side electrodes 102 having polarities and a plurality of reverse-side electrodes 104 having polarities and electrically connected to the obverse-side electrodes respectively. Under an opening in the metal frame 107, on the obverse-side electrodes 102 having polarities, a die-bonding resin or die-bonding sheet 110 is applied or adhered, and a plurality of LED elements 111 are mounted individually. One electrode 113 of each LED element is connected by a fine metal wire 112 to one obverse-side electrode 102, and another electrode 113 of the same LED element is connected by a fine metal wire 112 to another obverse-side electrode 102. The LED elements 111 and the fine metal wires 112 are then sealed in resin 114.

Patent Document 1: JP-A-2005-229003
Documents US 2004/264 141, US 2004/041 222 and US 2004/223 327 also disclose relevant prior art.

### Disclosure of the Invention

### Problems to be Solved by the Invention

In the conventional electronic component mounting board described above, the leg portions 137 of the metal frame 107 fitted to the circuit board 106 and formed from a metal block is firmly fitted to the board with solder or the like, so that the heat the LED elements 111 generate as they emit light is dissipated via the leg portions 137 of the metal frame 107 to the board, thereby achieving enhanced heat dissipation performance. The structure here is such that, with the circuit board 106 formed of a resin laminate or the like serving as a supporting plate, the metal frame 107 is fitted thereto with the adhesive layer 108 and then the LED elements 111 are amounted and sealed in resin. The heat generated by the LED elements 111 conducts via the obverse-side electrodes 102, which are formed as metal members having high thermal conductivity (typically formed of Cu, having a thermal conductivity of 403 W/m·K). Laid on the obverse-side electrodes 102, however, is the adhesive layer 108, which is formed of a resin, such as epoxy resin or acrylic resin, having a low thermal conductivity of 1.0 W/m·K or less; in addition, the structure involves sealing with the resin 114, such as epoxy resin or silicone resin, which has a low thermal conductivity of 1.0 W/m·K or less. Thus, the top side of the obverse-side electrodes 102 is shut off with a member having a low thermal conductivity, and this hampers efficient conduction of the heat generated by the LED elements 111 to the metal frame 107. This makes it impossible to make efficient use of the high thermal conductivity of the metal frame 107, and imposes definite limits, ascribable to the rise in the temperature of the LED elements 111, in terms of brightness and lifetime.

Moreover, the circuit board 106 and the frame 107 are typically fitted together with an adhesive layer 108, and the light emitted from the LED elements 111 is transmitted through the adhesive layer 108, causing leakage of light and resulting in a loss in the brightness of a surface-mounting LED.

An object of the present invention is to provide an electronic component mounting board so structured as to be free from the inconveniences discussed above, and to provide a method of fabricating such a board.

### Means for Solving the Problem

According to the invention of claim 1, an electronic component mounting board has a heat-conductive frame on the top surface of a circuit board having a plurality of conductors formed thereon, and the frame is heat-conductively connected to, among the plurality of conductors, a semiconductor element mount conductor on which a semiconductor element is to be mounted. The heat generated by a LED element (hereinafter referred to as a "semiconductor element" as a notion including a LED element) is efficiently dissipated to outside air from the surface of the frame, directly or indirectly via the frame. Thus, the rise in the temperature of the semiconductor element is reduced.

According to the invention of claim 2, in the electronic component mounting board of claim 1, the frame on the circuit board has no electrical polarity. Thus, the rise in the temperature of the semiconductor element is reduced.

According to the invention of claim 3, in the electronic component mounting board of claim 1, the frame has one electrical polarity. Thus, the rise in the temperature of the semiconductor element is reduced.

According to the invention of claim 4, in the electronic component mounting board of claim 1, an opening is formed in an end surface of the circuit board and the semiconductor element mount conductor is heat-conductively connected to a conductor formed on a bottom surface of the circuit board; the frame and the conductor formed on the bottom surface of the circuit board are heat-conductively connected together via a metal layer-formed in the board opening. Thus, the rise in the temperature of the semiconductor element is reduced.

According to the invention of claim 5, in the electronic component mounting board of claim 1, the frame and the semiconductor element mount conductor on the circuit board are heat-conductively connected together by being coated with a metal layer. Thus, the rise in the temperature of the semiconductor element is reduced. Moreover, when an LED element is mounted, no leakage of light as experienced in conventional electronic component mounting boards occurs.

According to the invention of claim 6, in the electronic component mounting board of claim 1, the frame and the semiconductor element mount conductor on the circuit board are heat-conductively connected together by being mechanically connected. Thus, the rise in the temperature of the semiconductor element is reduced. Moreover, when an LED element is mounted, no leakage of light as experienced in conventional electronic component mounting boards occurs.

According to the invention of claim 7, in the electronic component mounting board of claim 1, the frame and the semiconductor element mount conductor on the circuit board are heat-conductively connected together by being welded together. Thus, the rise in the temperature of the semiconductor element is reduced. Moreover, when an LED element is mounted, no leakage of light as experienced in conventional electronic component mounting boards occurs.

According to the invention of claim 8, in the electronic component mounting board, the frame and the semiconductor element mount conductor on the circuit board are heat-conductively connected together as a result of an electrically conductive projection being formed on the frame or the semiconductor element mount conductor on the circuit board and the frame and the semiconductor element mount conductor on the circuit board being connected together via the projection. Thus, the rise in the temperature of the semiconductor element is reduced.

According to the invention of claim 9, in the electronic component mounting board of claim 8, the projection is formed around a bottom opening formed in the frame, or is formed so as to close the bottom opening formed in the frame. Thus, the rise in the temperature of the semiconductor element is reduced. Moreover, when an LED element is mounted, no leakage of light as experienced in conventional electronic component mounting boards occurs.

According to the invention of claim 10, in the electronic component mounting board of claim 1, an LED element is mounted on the semiconductor element mount conductor on the circuit board. Thus, the rise in the temperature of the semiconductor element is reduced. Moreover, no leakage of light occurs in the electronic component mounting boards of particular claims.

### Advantages of the Invention

In the electronic component mounting board of the invention described in claim 1, the heat generated by a semiconductor element conducts to a heat-conductive frame directly or indirectly via a semiconductor element mount conductor formed on a circuit board and is then dissipated from the surface of the frame to outside air. Thus, the rise in the temperature of the semiconductor element is reduced. In particular, with a surface-mounting LED, the rise in the temperature of the LED element is reduced, resulting in high brightness proportional to current and in enhanced lifetime.

In the electronic component mounting board of the invention described in claim 2, the frame on the circuit board has no electrical polarity. Thus, the frame can be heat-conductively connected to a chassis having a higher heat-dissipating effect, resulting in a higher heat-dissipating effect.

In the electronic component mounting board of the invention described in claim 3, the frame on the circuit board has an electrical polarity. Thus, the frame offers an effect of dissipating the heat generated by the semiconductor element and can also be used as a connection terminal related to the driving of the semiconductor element.

In the electronic component mounting board of the invention described in claim 4, a board opening is formed in an end surface of the circuit board, so that any conductor formed on the reverse side of the circuit board can be heat-conductively connected to the frame through the board opening. Thus, as in the foregoing, the rise in the temperature of the semiconductor element is reduced.

In the electronic component mounting board of the invention described in claim 5, the frame and the surface of the semiconductor element mount conductor on the circuit board are heat-conductively connected together by being coated with a metal layer. This permits heat to conduct from the semiconductor element mount conductor to the frame via the metal layer without being thermally obstructed by an adhesive layer or the like. Thus, as in the foregoing, the rise in the temperature of the semiconductor element is reduced. In particular, with a surface-mounting LED, an adhesive layer, which causes leakage of light, is coated with the metal layer, and this offers a light-shielding effect, resulting in enhanced brightness.

In the electronic component mounting board of the invention described in claim 6, the frame and the semiconductor element mount conductor on the circuit board can be heat-conductively connected together without an adhesive layer by being mechanically connected as with a rivet, screw, or the like. Thus, the heat generated by the semiconductor element can be dissipated efficiently from the surface of the frame to outside air.

In the electronic component mounting board of the invention described in claim 7, the frame and the semiconductor element mount conductor on the circuit board can be heat-conductively connected together with, instead of an adhesive layer, a metal diffusion layer formed by welding such as brazing, soldering, ultrasonic welding, or the like. Thus, the heat generated by the semiconductor element can be dissipated efficiently from the surface of the frame to outside air. In particular, with a surface-mounting LED, the absence of an adhesive layer, which causes leakage of light, permits the circuit board and the frame to be shielded from each other, resulting in enhanced brightness.

In the electronic component mounting board of the invention described in claim 8, the frame and the semiconductor element mount conductor on the circuit board are heat-conductively connected together via an electrically conductive projection formed on the frame or the semiconductor element mount conductor on the circuit board. Thus, the heat generated by the semiconductor element can be dissipated from the surface of the frame to outside air.

In the electronic component mounting board of the invention described in claim 9, the projection mentioned in claim 8 is formed around a bottom opening formed in the frame, or is formed so as to close the bottom opening formed in the frame. In particular, with a surface-mounting LED, the heat generated by the LED element can be dissipated from the surface of the frame to outside air; moreover, the light emitted from the LED element is shielded by the projection, resulting in enhanced brightness.

As described in claim 10, the electronic component mounting boards of the invention described in the foregoing are suitable for surface-mounting LEDs. The heat generated by the LED element is efficiently dissipated to outside air from the surface of the frame via the semiconductor element mount conductor on the circuit board. Thus, the rise in the temperature of the LED element is reduced, resulting in high brightness proportional to current and in enhanced lifetime.

The electronic component mounting boards of particular claims described in the foregoing also offers a light-shielding effect, resulting in enhanced brightness.

Thus, by employing an electronic component mounting board of the invention in a surface-mounting LED, it is possible to obtain enhanced functionality and enhanced reliability in terms of product quality, and to obtain enhanced light emission efficiency per LED element. Thus, it is possible to reduce the number of unit elements conventionally needed to secure a given level of brightness, exerting a great economic effect.

By use of the electronic component mounting board described in claim 14 in the region where adhesive exists in between, it is possible to obtain satisfactory adhesion strength between the circuit board and the frame; in the region where the frame and the semiconductor element mount conductor make contact with each other, it is possible to achieve electrical and heat-conductive connection between the frame and the semiconductor element mount conductor. Thus, the heat generated by the semiconductor element conducts to the semiconductor element mount conductor, and then efficiently conducts to the frame in the region where the frame and the semiconductor element mount conductor make contact with each other. This reduces the rise in the temperature of the LED element, resulting in high brightness more proportional to current and in enhanced lifetime.

### Brief Description of Drawings

[Fig. 1A] A perspective view of an electronic component mounting board as a first example, see-through to show internal conductors.
[Fig. 1B] An exploded view, corresponding to Fig. 1A, of the first example.
[Fig. 1C] A sectional view taken along line A-A' in Fig. 1A.
[Fig. 1D] A sectional view taken along line B-B' in Fig. 1A.
[Fig. 2A] An exploded view of the board of a second example.
[Fig. 2B] A sectional view of the board taken along line A-A' in Fig. 2A.
[Fig. 2C] A sectional view of the board taken along line B-B' in Fig. 2A.
[Fig. 3A] An exploded view of the board of a first embodiment of the invention.
[Fig. 3B] A sectional view of the board taken along line A-A' in Fig. 3A.
[Fig. 3C] A sectional view of the board taken along line B-B' in Fig. 3A.
[Fig. 4A] An exploded view of the board of a third example.
[Fig. 4B] A sectional view of the board taken along line A-A' in Fig. 4A.
[Fig. 4C] A sectional view of the board taken along line B-B' in Fig. 4A.
[Fig. 4D] A sectional view showing an obverse-side electrode 3 and a reverse-side electrode 5 connected together by a metal layer 9 in the board of the third example shown in Fig 4A.
[Fig. 4E] A sectional view showing an obverse-side electrode 3 and a reverse-side electrode 5 connected together by a metal layer 9 in the board of the third example shown in Fig 4A.
[Fig. 5A] A perspective view of the board of a fourth example.
[Fig. 5B] A sectional view taken along line C-C' in Fig. 5A.
[Fig. 6A] A perspective view of the board of a fifth example.
[Fig. 6B] A sectional view taken along line A-A' in Fig. 6A.
[Fig. 6C] A sectional view taken along line B-B' in Fig. 6A.
[Fig. 7A] A perspective view showing a chassis is fitted to a heat-conductive frame 7 or metal frame 21 having no polarity in an example of the invention.
[Fig. 7B] A sectional view taken along line B-B' in Fig. 7A.

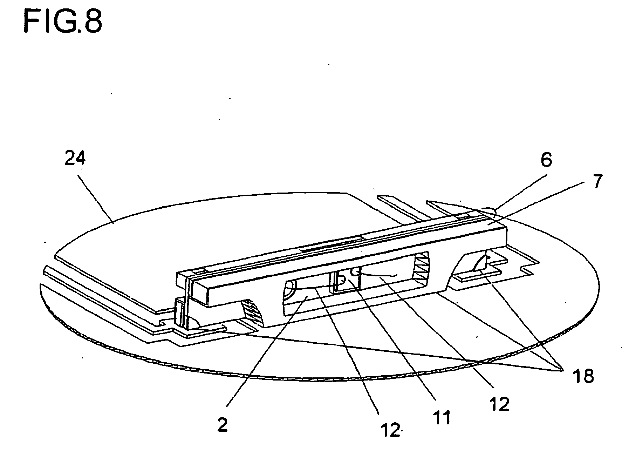

[Fig. 8] A perspective view showing a heat-conductive frame 7 having a polarity fitted to a circuit board 24 in an example of the invention.
[Fig. 9A] A perspective view of the board of a sixth example.
[Fig. 9B] A sectional view taken along line B-B' in Fig. 9A.
[Fig. 10A] A perspective view of the board of a seventh example.
[Fig. 10B] A sectional view taken along line B-B' in Fig. 10A.
[Fig. 11A] A perspective view of the board of an eighth example.
[Fig. 11B] A sectional view taken along line B-B' in Fig. 11A.
[Fig. 11C] A sectional view showing a heat-conductive frame 7 and an obverse-side electrode 3 heat-conductively connected together by swaging in the eighth example.
[Fig. 12A] A perspective view of the board of a second embodiment of the invention.
[Fig. 12B] A sectional view taken along line B-B' in Fig. 12A.
[Fig. 12C] A sectional view showing a heat-conductive frame 7 and an obverse-side electrode 3 heat-conductively connected together as a result of a frame depression 35 formed in the former and an electrically conductive projection 28 formed on the latter being brought into insertion contact with each other in the second embodiment.
[Fig. 13A] An exploded view of the board of a third embodiment of the invention.
[Fig. 13B] A sectional view taken along line B-B' in Fig. 13A.
[Fig. 13C] A sectional view showing a structure in which the electrically conductive projection 28 of the third embodiment is formed so as to close a bottom opening 29 in the heat-conductive frame 7 so that the heat-conductive frame 7 and the obverse-side electrode 3 are heat-conductively connected.
[Fig. 14] Sectional views of modified examples of the third embodiment, (A) showing a metal layer 9 deposited on a heat-conductive frame 7, an electrically conductive projection 28, and an obverse-side electrode 3, (B) showing the metal layer 9 grown in the thickness direction thereof.
[Fig. 15] Sectional views illustrating the process of forming the metal layer 9 of the first example by electrolytic plating, (A) showing the growth of the metal layer 9 from the heat-conductive frame 7 and the growth of the metal layer 9 from the obverse-side electrode 3, (B) showing an insulating adhesive layer 8 coated with the metal layer 9, and (C) showing the coating metal layer 9 grown in the thickness direction thereof.
[Fig. 16A] A perspective view of the board of a modified example of the first example.
[Fig. 16B] A sectional view taken along line A-A' in Fig. 16A.
[Fig. 17A] A sectional view of the board of a ninth example.
[Fig. 17B] A sectional view of a modified example of the ninth example.
[Fig. 18] Diagrams showing the steps of fabricating the electronic component mounting board of the fifth example, (A) showing the first step, (B) showing the second step, (C) showing the third step, (D) showing the fourth step, (E) showing the fifth step, (F) showing the second step.
[Fig. 19] Diagrams showing the steps of fabricating the electronic component mounting board of the first example, (A) showing the first step, (B) showing the second step, (C) showing the third step, (D) showing the fourth step.

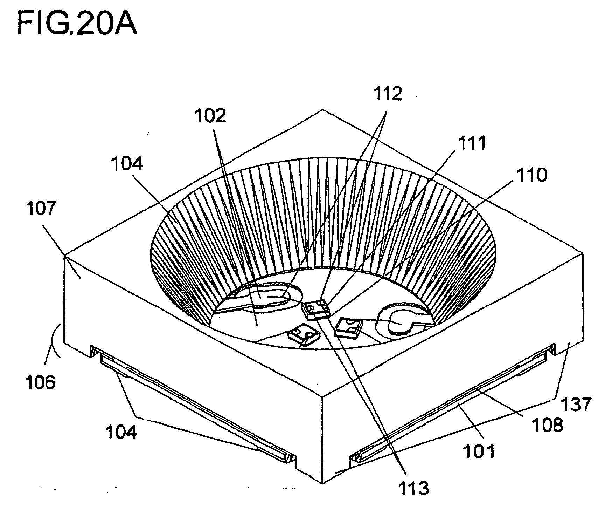

[Fig. 20A] A perspective view of a conventional electronic component mounting board.

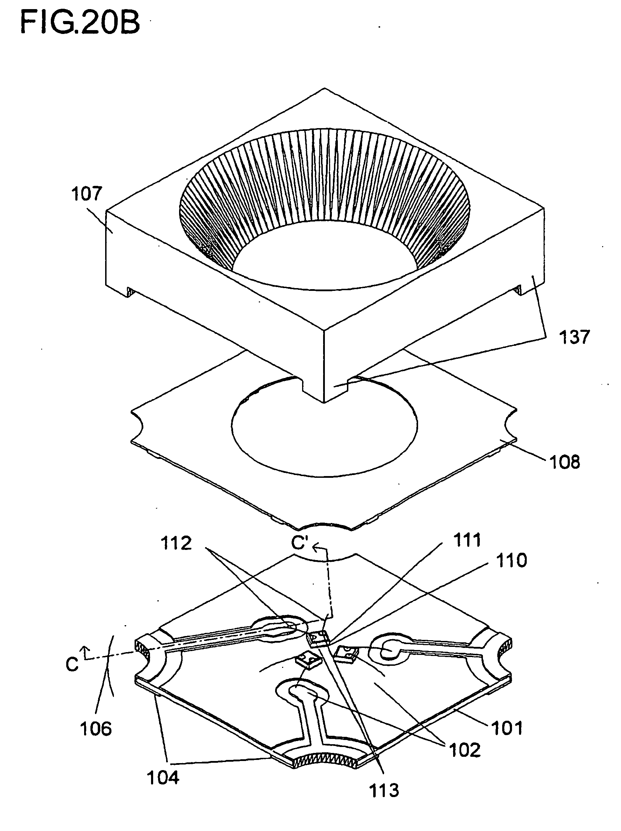

[Fig. 20B] An exploded view of Fig. 20A.

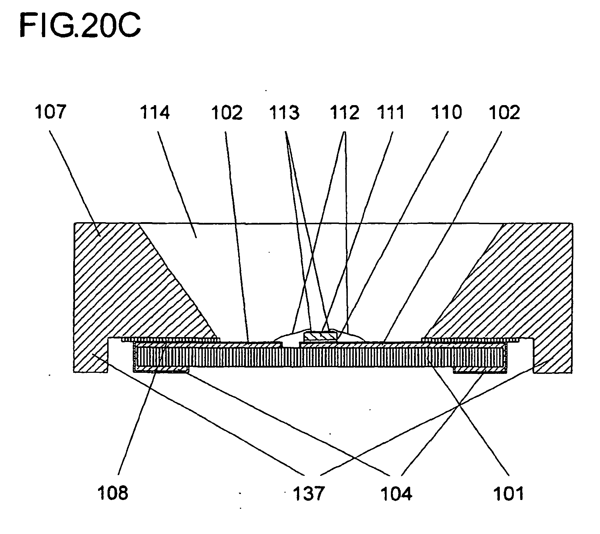

[Fig. 20C] A sectional view of Fig. 20A.

### List of Reference Symbols

- 1: Insulating base member
- 2: Obverse-side electrode having a polarity (conductive)
- 3: Obverse-side electrode having no polarity (conductive)
- 4: Reverse-side electrode having a polarity (conductive)
- 5: Reverse-side electrode having no polarity (conductive)
- 6: Circuit board
- 7: Heat-conductive frame
- 8: Adhesive layer
- 9, 9a, 9b: Metal layer
- 10: Die-bonding resin or die-bonding sheet
- 11: LED element (semiconductor element)
- 12: Fine metal wire
- 13: LED element electrode
- 14: Resin
- 15: Through hole
- 16, 16a, 16b, 16c: Metal surface-treatment layer
- 17: Insulating resin
- 18: Welded portion
- 19: LED mounting hole
- 21: Metal frame
- 22: Chassis
- 24: Board
- 25: Board opening
- 26: Frame opening
- 27: Rivet
- 28, 28a: Electrically conductive projection
- 29: Heat-conductive frame bottom opening
- 30: Metal diffusion layer
- 31: Barrier metal layer
- 32: Plated-metal layer
- 33: Etching resist layer
- 34: Swaged portion
- 35: Frame depression
- 36: Contact portion
- 37: Divide portion
- 38: Zener element
- 101: Insulating base member
- 102: Obverse-side electrode having a polarity (conductive)
- 104: Reverse-side electrode having a polarity (conductive)
- 106: Circuit board
- 107: Metal frame
- 108: Adhesive layer
- 110: Die-bonding resin or die-bonding sheet
- 111: LED element
- 112: Fine metal wire
- 113: LED element electrode
- 114: Resin
- 137: Metal frame leg

### Best Mode for Carrying Out the Invention

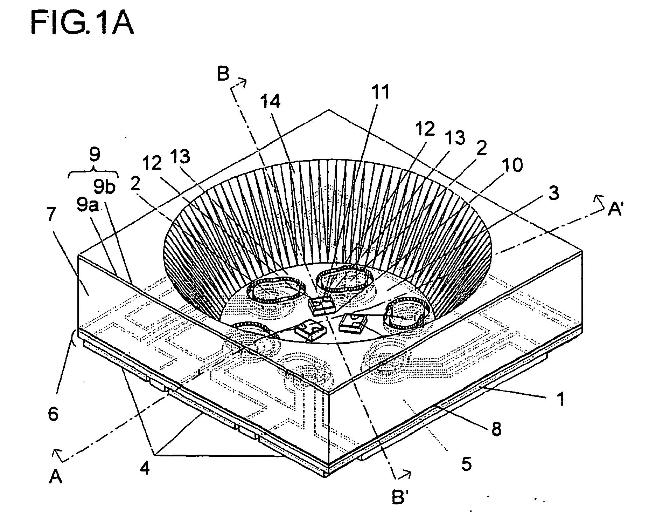

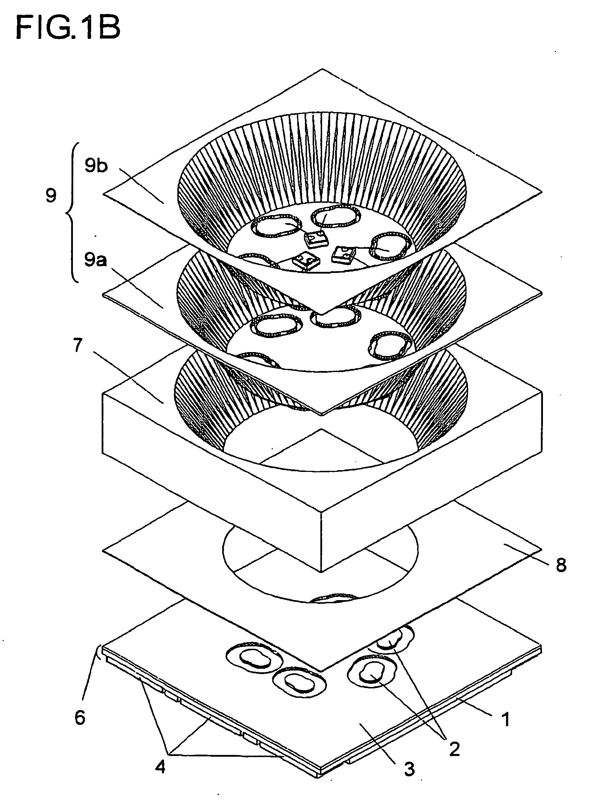

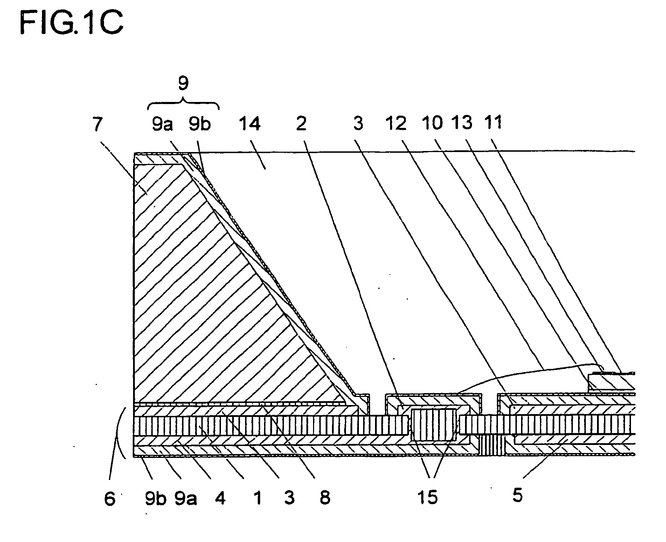

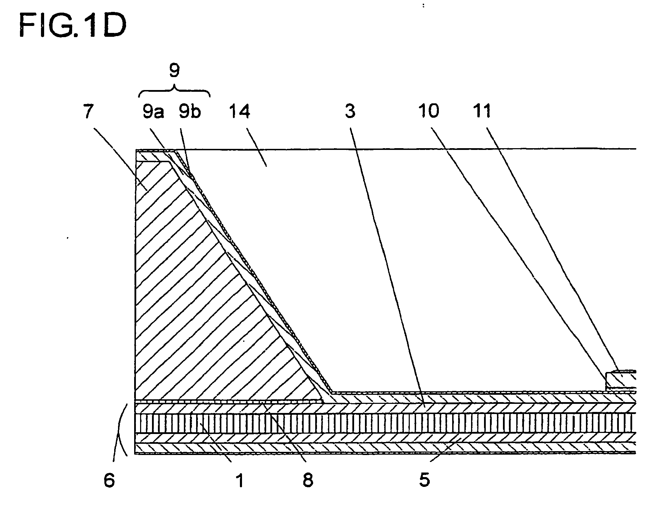

Hereinafter, with reference to the accompanying drawings, electronic component mounting boards and their fabrication methods according to the invention will be described in detail. Figs. 1A to 1C show the electronic component mounting board of a first example, Fig. 1A being a perspective view see-through to show internal conductors, Fig. 1B being an exploded view, Fig. 1C being a sectional view taken along line A-A' in Fig. 1A, Fig. 1D being a sectional view taken along line B-B' in Fig. 1A.

A detailed description follows. A circuit board 6 has, formed on the top surface of an insulating base member 1, a plurality of conductors - a plurality of obverse-side electrodes 2 each having a positive or negative polarity (hereinafter referred to as the obverse-side electrodes 2 having a polarity) and one or more obverse-side electrodes 3 having no polarity. The circuit board 6 further has, formed on the bottom surface of the insulating base member 1 and electrically connected to the obverse-side electrodes respectively, a plurality of reverse-side electrodes 4 each having a positive or negative polarity (hereinafter referred to as the reverse-side electrodes 4 having a polarity) and one or more reverse-side electrodes 5 having no polarity. Next, on the circuit board 6, on the top surface of the obverse-side electrodes 3 having no polarity, a frame 7 that conducts heat (hereinafter referred to as the heat-conductive frame 7) is adhered by use of an adhesive layer 8.

A metal layer 9 (of which part 9a is for heat conduction and a part 9b is for surface treatment) is formed to coat the surface of the heat-conductive frame 7, of the obverse-side electrodes 3 having no polarity, and of the adhesive layer 8 formed in between, so that the heat-conductive frame 7 and the obverse-side electrode 3 having no polarity are heat-conductively connected with the metal layer 9 (see Fig. 1D). Furthermore, the structure is such that on the circuit board 6, on the obverse-side electrodes 3 having no polarity, LED elements 11 are mounted by use of a die-bonding resin or die-bonding sheet 10; that one electrode 13 of each LED element is connected to an obverse-side electrode 2 having one electrical polarity with a fine metal wire 12; that the other electrode 13 of each LED element is connected to an obverse-side electrode 2 having the other electrical polarity with a fine metal wire 12; and that the LED elements 11 and the fine metal wires 12 are sealed in resin 14 (see Fig. 1C).

According to Figs. 1A to 1C, the heat generated by the LED elements 11 is dissipated to outside air via the path across the obverse-side electrode 3 having no polarity and then across the metal layer 9; thus, the heat generated by the LED elements 11 is dissipated efficiently to outside air. This reduces the rise in the temperature of the LED elements 11, resulting in high brightness proportional to current and in enhanced lifetime. In particular, in a case where the heat-conductive frame 7 is formed as a metal member, the volume of the metal that serves as the medium for heat dissipation and the area of the contact surface with outside air that is involved in heat dissipation increase, and thus the heat generated by the LED elements 11 is dissipated more efficiently to outside air, enhancing the just-mentioned effect.

As will be understood from the drawings mentioned above, since the interfaces of the adhesive layer 8 used to fit together the circuit board 6 and the heat-conductive frame 7 is coated with the metal layer 9, no leakage of light occurs, and thus the problem that invites a loss in the brightness of a surface-mounting LED is improved; in addition, since the structure is such that the heat-conductive frame 7 and the circuit board 6 are connected together by the metal layer 9, the adhesion strength between the heat-conductive frame 7 and the circuit board 6 is enhanced.

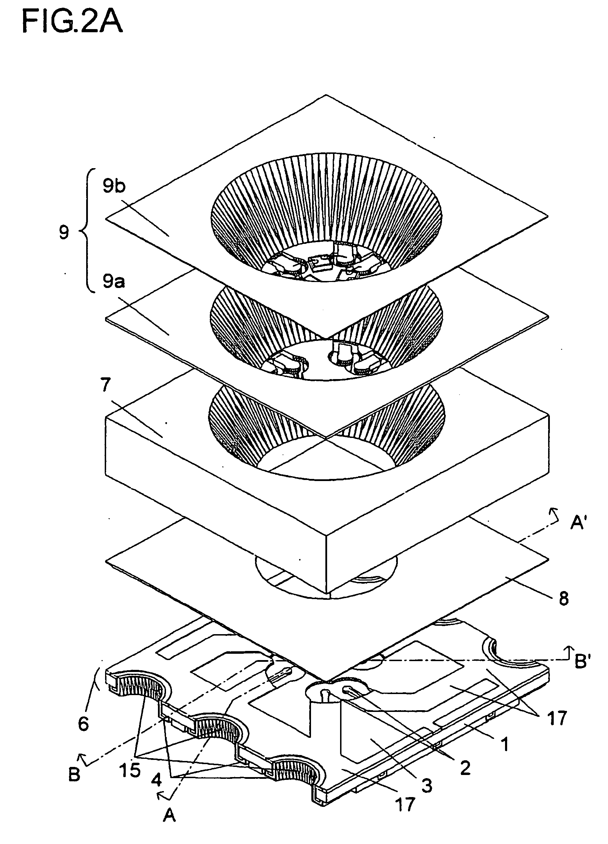

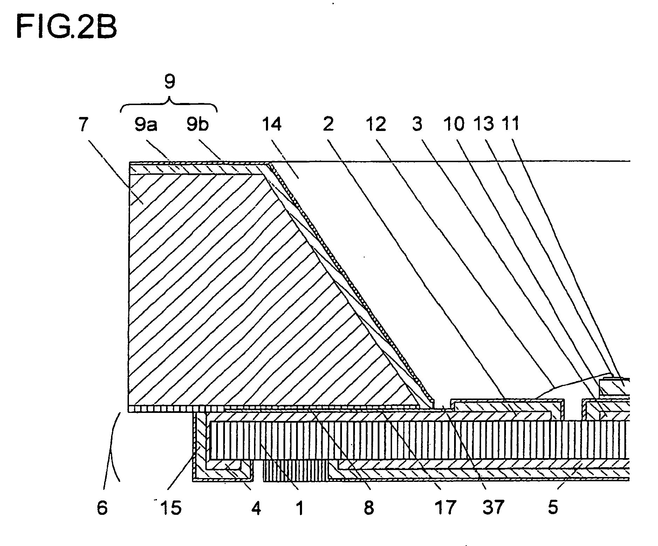

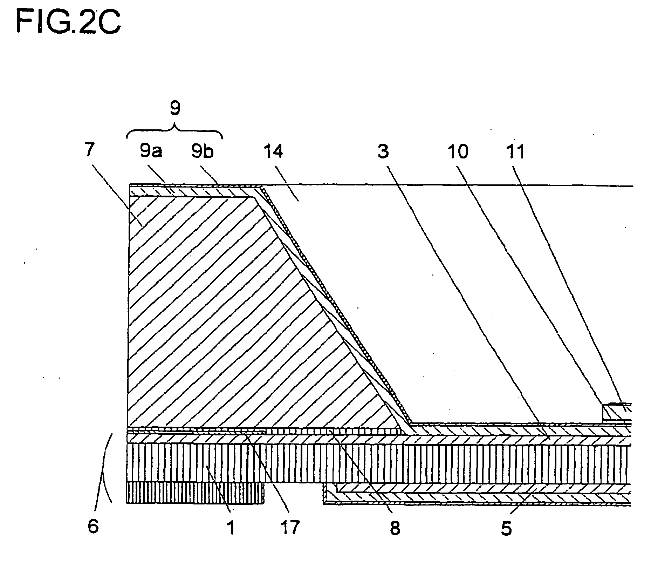

Figs. 2A to 2C show the electronic component mounting board of a second example, Fig. 2A being an exploded view, Fig. 2B being a sectional view of the board taken along line A-A' in Fig. 2A, and Fig. 2C being a sectional view of the board taken along line B-B' in Fig. 2A. A circuit board 6 is so structured that, on an insulating base member 1, there are formed an obverse-side electrode 3 having no polarity and an obverse-side electrode 2 having a polarity which is electrically connected, via through holes 15 formed at an end face of the circuit board 6, to a reverse-side electrode 4 having a polarity. In this circuit board 6, the part of the obverse-side electrode 2 having a polarity except where the fine metal wire 12 is connected thereto is coated with an insulating resin 17; a heat-conductive frame 7 and the obverse-side electrode 3 having no polarity are adhered together with an adhesive layer 8; and a metal layer 9 is formed so that the heat-conductive frame 7 and the obverse-side electrode 3 is heat-conductively connected together by the adhesive layer 8.

In a case where, as shown in Figs. 2A to 2C, an obverse-side electrode 2 having one polarity is, or obverse-side electrodes 2 having both polarities are, formed under a heat-conductive frame 7, if the heat-conductive frame 7 (here assumed to have a metal surface) and the obverse-side electrodes are adhered together using the adhesive layer 8 alone, when the heat-conductive frame 7 and the obverse-side electrodes are adhered together, the heat-conductive frame 7 may make contact (penetration) with the electrodes. Moreover, short-circuiting occurs also when the heat-conductive frame 7 and the obverse-side electrodes are electrically connected by the metal layer 9. Thus, the obverse-side electrodes 2 having one or both polarities are previously coated with the insulating resin 17 to avoid the obverse-side electrodes 2 having polarities being simultaneously connected to the heat-conductive frame 7. Thus, an effect equivalent to that obtained in the first example is obtained.

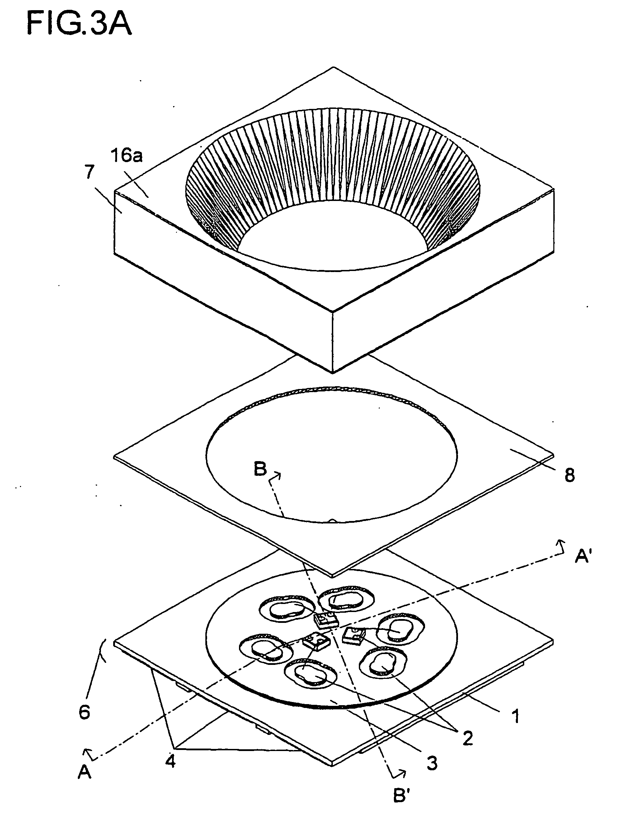

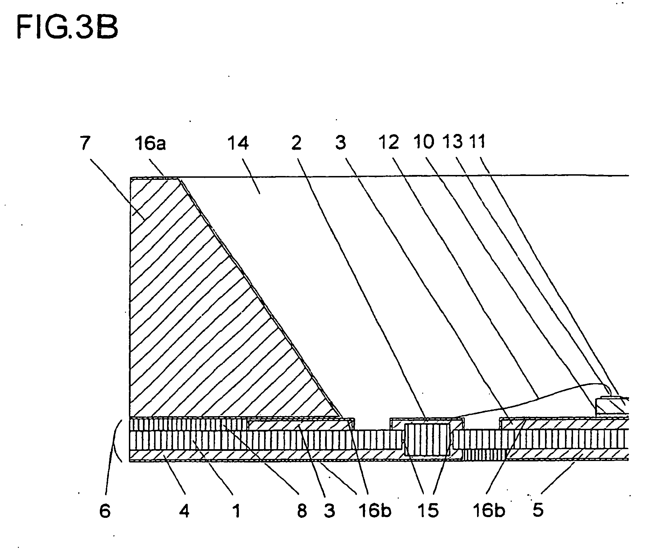

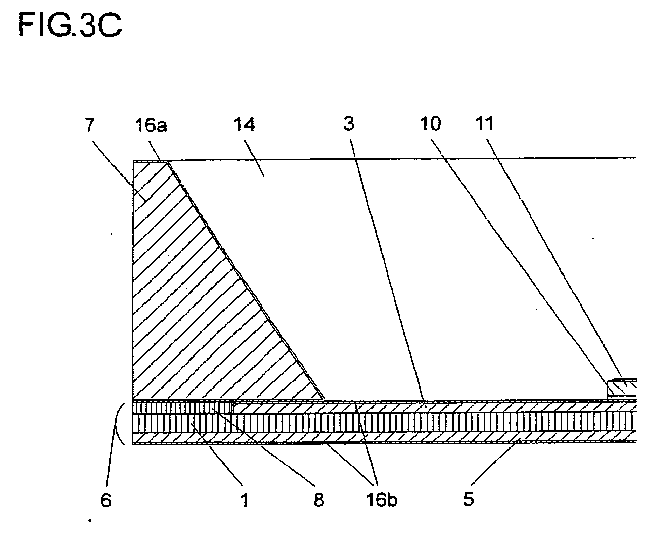

Figs. 3A to 3C show the electronic component mounting board of a first embodiment of the invention, Fig. 3A being an exploded view, Fig. 3B being a sectional view taken along line A-A' in Fig. 3A, and Fig. 3C being a sectional view taken along line B-B' in Fig. 3A. The circumferential part of the obverse-side electrode 3 having no polarity - the part thereof located under the heat-conductive frame 7 - shown in Fig. 1A of the first example is removed, so that an obverse-side electrode 3 is formed to have a circular shape (or any other shape). On the exposed part of the insulating base member 1, an adhesive layer 8 is applied or adhered and a heat-conductive frame 7 is bonded and thereby fixed. Thus, the heat-conductive frame 7 and the obverse-side electrode 3 are brought into contact with each other and thereby heat-conductively connected together (the reference signs 16a and 16b represent metal surface-treatment layers).

As shown in Figs. 3A to 3C, the adhesive layer 8 formed between the heat-conductive frame 7 and the obverse-side electrode 3 having no polarity shown in the drawings of the first example no longer exists. Thus, even without a metal layer 9 being formed, the heat-conductive frame 7 and the obverse-side electrode 3 are brought into contact with each other and thereby heat-conductively connected together, and an effect equivalent to that obtained in the first example is obtained. Moreover, in the thermocompression process, the obverse-side electrode 3 prevents the adhesive layer 8 from seeping into the heat-conductive frame 7, thereby offering a dam effect.

Instead of completely removing the circumferential part of the obverse-side electrode 3 as described above, a step may be provided so that, on a similar principle, on the floor part of the step, an adhesive layer 8 is applied or adhered and a heat-conductive frame 7 is bonded and thereby fixed (unillustrated).

The heat-conductive frame 7 and the obverse-side electrode 3 of the third example may be heat-conductively connected together with the metal layer 9 used in the first and second examples. This enhances the heat-dissipating effect (unillustrated).

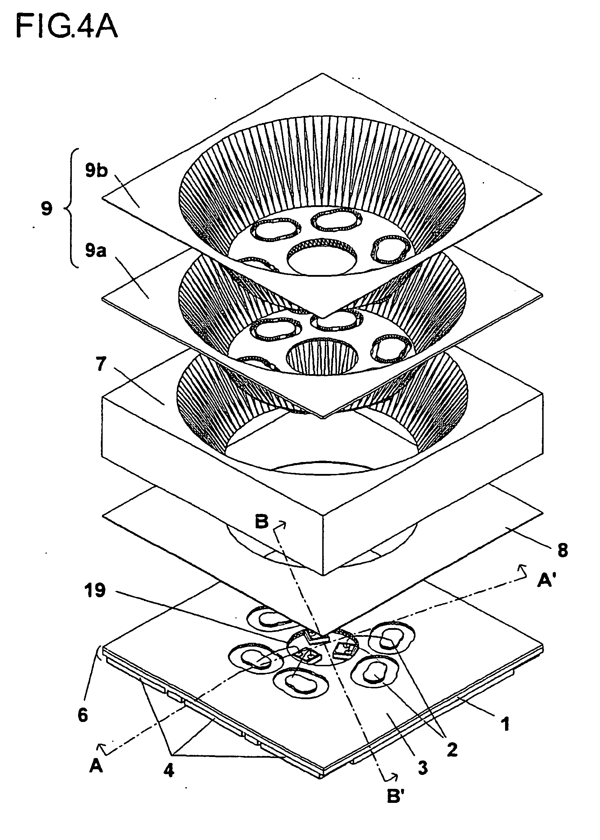

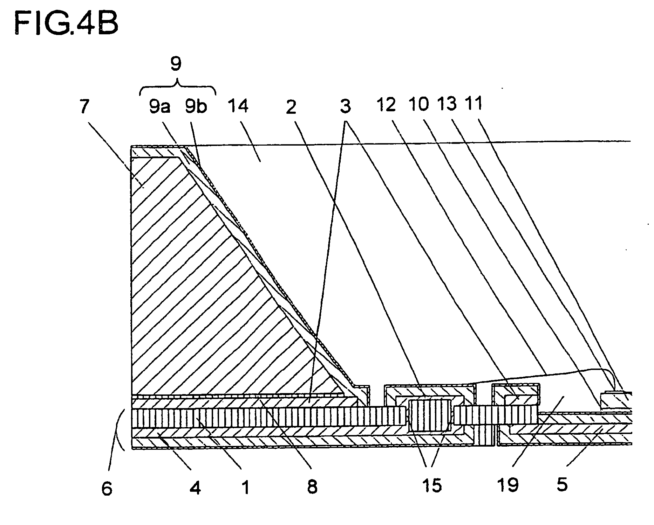

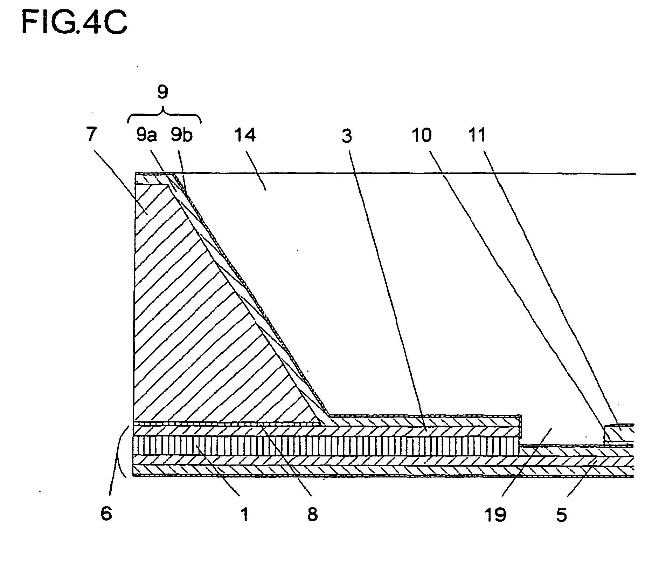

Figs. 4A to 4C show the electronic component mounting board of a third example, Fig. 4A being an exploded view, Fig. 4B being a sectional view taken along line A-A' in Fig. 4A, and Fig. 4C being a sectional view taken along line B-B' in Fig. 4A. The circuit board 6 has, arranged at predetermined intervals, reverse-side electrodes 4 shared as a support plate and each having a positive or negative polarity and reverse-side electrodes 5 having no polarity, and holds these reverse-side electrodes. Moreover, the circuit board 6 has a LED mounting hole 19 formed therein. Furthermore, the circuit board 6 has obverse-side electrodes 2 each having a polarity which are electrically connected to the reverse-side electrodes 4 having polarities respectively, and has obverse-side electrodes 3 having no polarity. Next, a heat-conductive frame 7 and the obverse-side electrodes 3 are adhered together with an adhesive layer 8, and the heat-conductive frame 7 and the obverse-side electrodes 3 are heat-conductively connected by a metal layer 9. Furthermore, on the reverse-side electrodes 5 having no polarity which is formed on the circuit board 6, by use of a die-bonding resin or die-bonding sheet 10, LED elements 11 are mounted; then, the electrodes 13 of the LED elements and the reverse-side electrodes 4 having electrical polarities are connected together by fine metal wires 12 respectively; then sealing with resin 14 is applied.

Even in a case where, as shown in Figs. 4A to 4C, the electrodes on which the LED elements 11 are mounted (here, the reverse-side electrodes 5 having no polarity) and the heat-conductive frame 7 are not heat-conductively connected together, the heat generated by the LED elements 11 conducts, indirectly across the resin 14 and via the obverse-side electrodes 3 having no polarity, or directly, to the heat-conductive frame 7. Thus, the heat generated by the LED elements 11 is dissipated efficiently to outside air.

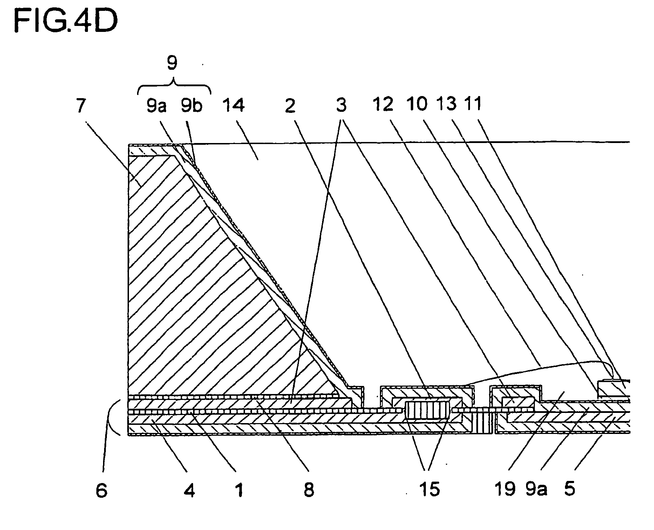

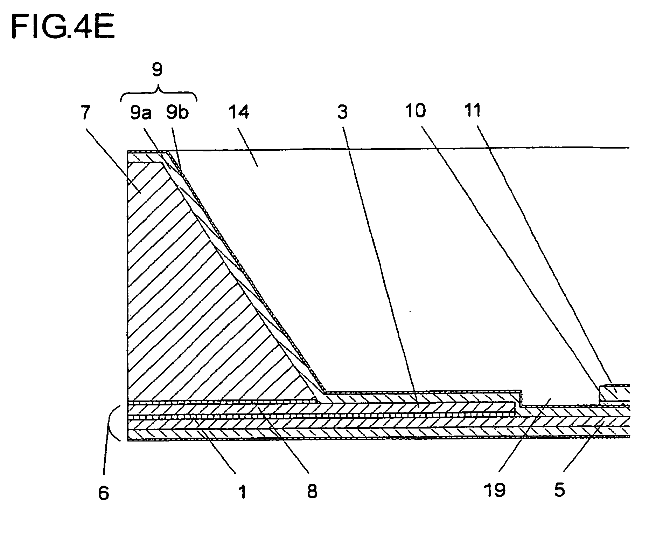

As shown in Figs. 4D and 4E, the reverse-side electrodes 5 having no polarity on which the LED elements 11 are mounted may instead be heat-conductively connected to the obverse-side electrodes 3 having no polarity by the metal layer 9. Thus, the heat generated by the LED elements 11 more efficiently conducts to the heat-conductive frame 7. This offers a higher heat-dissipating effect than the structure shown in Figs. 4B and 4C.

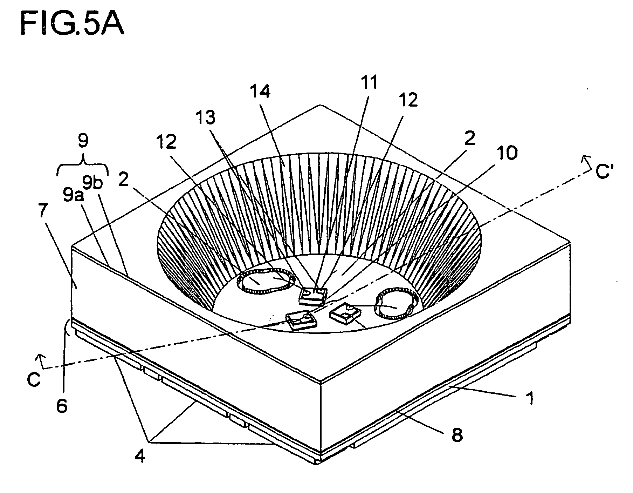

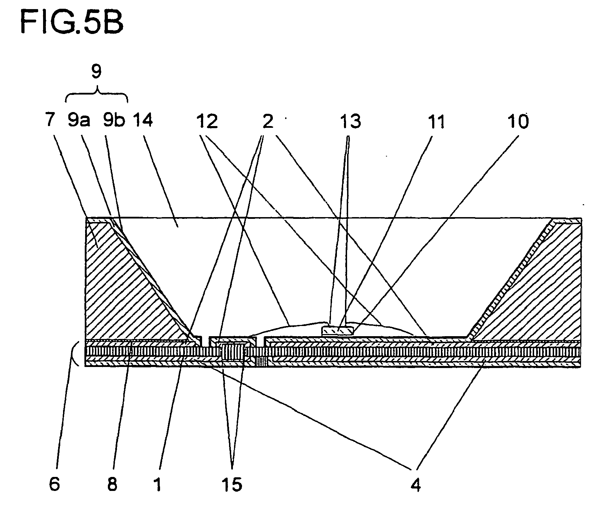

Figs. 5A and 5B show the electronic component mounting board of a fourth example, Fig. 5A being a perspective view, and Fig. 5B being a sectional view taken along line C-C' in Fig. 5A. The obverse-side electrode 3 having no polarity which is formed on the circuit board 6 in the first example is not formed in this example. Instead, obverse-side electrodes 2 each having a positive or negative polarity are formed, and the obverse-side electrode 2 having one - positive or negative - polarity and a heat-conductive frame 7 are adhered together by use of an adhesive layer 8; then, a metal layer 9 is formed so that the heat-conductive frame 7 and the obverse-side electrode 2 having one polarity is electrically and heat-conductively connected together by the metal layer 9.

By mounting LED elements 11 on the electronic component mounting board structured as described above and then applying sealing with resin 14 as shown in Figs. 5A and 5B, it is possible to obtain an effect equivalent to that obtained in the first example.

In a case where, in Figs. 5A and 5B, the LED elements 11 mounted have LED element electrodes 13 on the top and bottom surfaces thereof, by use of an electrically conductive die-bonding resin or die-bonding sheet 10, the LED elements 11 are mounted on obverse-side electrodes 2 having one polarity so that these obverse-side electrodes 2 are connected to the electrodes 13 formed on the bottom surface of the LED elements, and obverse-side electrodes 2 having the other polarity and the electrodes 13 formed on the top surface of the LED elements may be connected together by fine metal wires 12 (unillustrated).

According to the invention and the first to fourth examples described above, used as the circuit board 6 is one having conductors formed on an insulating base member 1, or one composed of a plurality of insulating base members 1 laid together and each having conductors formed thereon, or one having an insulating material adhered to a leadframe, or the like.

The heat-conductive frame 7 is formed largely as a metal member of Al (having a thermal conductivity of 236 W/m·K), Fe (having a thermal conductivity of 83.5 W/m·K), Cu (having a thermal conductivity of 403 W/m·K), Mg (having a thermal conductivity of 157 W/m•K), or the like; or is a frame formed of ceramic or insulating resin having a thermal conductivity less than 10 W/m·K, with a metal layer deposited on the surface of the frame; or is a frame formed of a board material or the like containing a combination of a metal member, ceramic, and insulating resin, with a metal layer deposited on the surface of the frame.

To form a metal layer on the surface of the above-mentioned frame formed of ceramic or insulating resin having a thermal conductivity less than 10 W/m·K, or frame formed of a board material or the like containing a combination of a metal member, ceramic, and insulating resin, it is preferable to use sputtering, vapor deposition, electrolytic plating, electroless plating, or a combination of any two or more of these processes.

In a case where electroless plating is used, a catalyst may be mixed with an insulating frame material, such as ceramic or insulating resin, or may be deposited on the surface of the frame.

In a case where electrolytic plating is used, an electrically conductive material, such as carbon, may be deposited on the surface of an insulating frame material, such as ceramic or resin.

A surface layer of metal may further be formed on the surface of the above-mentioned frame formed largely as a metal member of Al, Fe, Cu, Mg, or the like.

The metal layer on the surface of the heat-conductive frame 7 may be a layer of Cu (having a thermal conductivity of 403 W/m·K), Ni (having a thermal conductivity of 94 W/m·K), Au (having a thermal conductivity of 319 W/m·K), Ag (having a thermal conductivity of 428 W/m·K), Pd (having a thermal conductivity of 72 W/m·K), Sn (having a thermal conductivity of 68 W/m·K), or Al (having a thermal conductivity of 236 W/m·K), or may composed of a plurality of layers of any two or more of these metals laid together.

Each conductor, namely an obverse-side electrode 2 having a polarity, obverse-side electrode 3 having no polarity, reverse-side electrode 4 having a polarity, or reverse-side electrode 5 having no polarity, is formed largely as a metal member of Al, Fe, Cu, or the like, or an alloy thereof.

It is preferable that the surface of each obverse-side electrode 2 having a polarity, obverse-side electrode 3 having no polarity, reverse-side electrode 4 having a polarity, and reverse-side electrode 5 having no polarity be plated with Cu, Ni, Au, Ag, Pd, or Sn, or with a plurality of layers of any two or more of these metals laid together.

It is preferable that the metal layer 9 be plated with Cu, Ni, Au, Ag, Pd, or Sn, or with a plurality of layers of any two or more of these metals laid together.

In a structure in which, as shown in the drawings of the third example, the heat-conductive frame 7 and the obverse-side electrode 3 are brought into contact with each other and thereby heat-conductively connected together, since there is no need to form a metal layer 9, the heat-conductive frame 7 may be formed of ceramic or insulating resin having a thermal conductivity of 10 W/m·K or more, or may be a frame of Al having a layer of anodized aluminum (having a thermal conductivity of 80 W/m·K) formed on the surface thereof.

The fine metal wires 12 are formed of metal such as Ag, Au, or Al.

Used as the die-bonding resin is epoxy resin, or a paste of epoxy resin or the like mixed with an electrically conductive material, for example metal such as Au, Ag, or Cu, or an alloy such as solder, or a metal oxide such as ITO or SnO₂. Used as the die-bonding sheet is a sheet of epoxy resin or the like.

Used as the resin 14 used to seal the LED elements 11 and the fine metal wires 12 is a translucent or fluorescent resin.

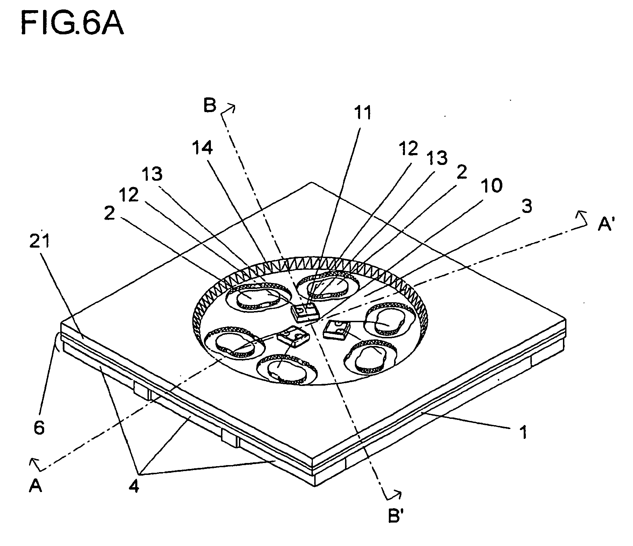

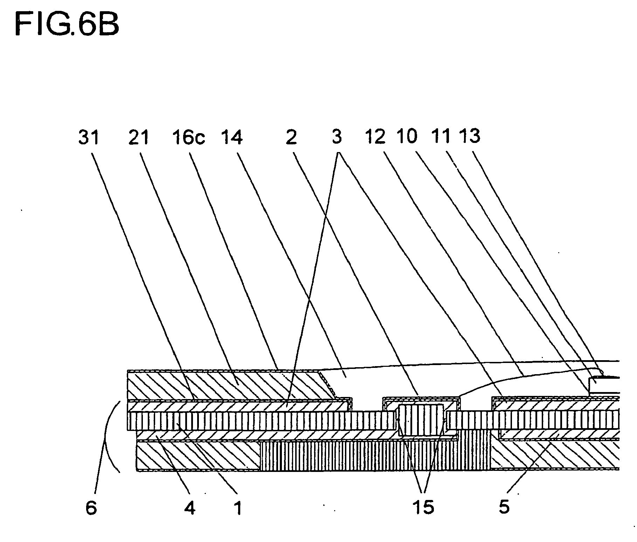

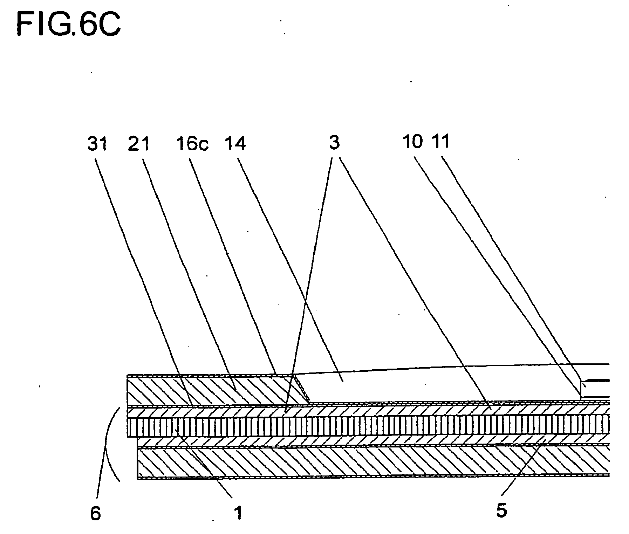

Figs. 6A to 6C show the electronic component mounting board of a fifth example, Fig. 6A being an exploded view, Fig. 6B being a sectional view taken along line A-A' in Fig. 6A, and Fig. 6C being a sectional view taken along line B-B' in Fig. 6A. On the circuit board 6 shown in the drawings of the first example, a metal frame 21 is formed from a metal layer deposited by plating, and the metal frame 21 and the obverse-side electrode 3 are heat-conductively connected and thereby structurally integrated together (the reference sign 16c represents a metal surface-treatment layer, and the reference sign 31 represents a barrier metal layer).

According to Figs. 6A to 6C, the metal frame 21 and the obverse-side electrode 3 on the circuit board 6 are heat-conductively connected and thereby structurally integrated together. Thus, without the need for an adhesive layer 8, it is possible to obtain an effect similar to that obtained in the first example.

It is preferable that the metal frame 21 be formed of Cu, Ni, Au, Ag, Pd, or Sn, or of a plurality of layers of any two or more of these metals laid together.

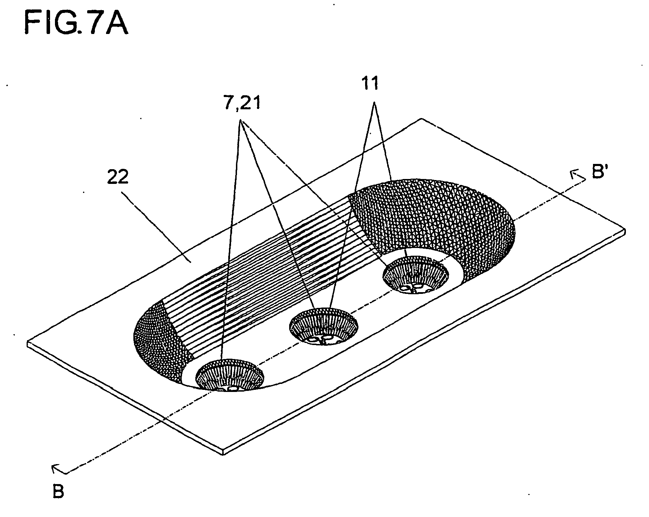

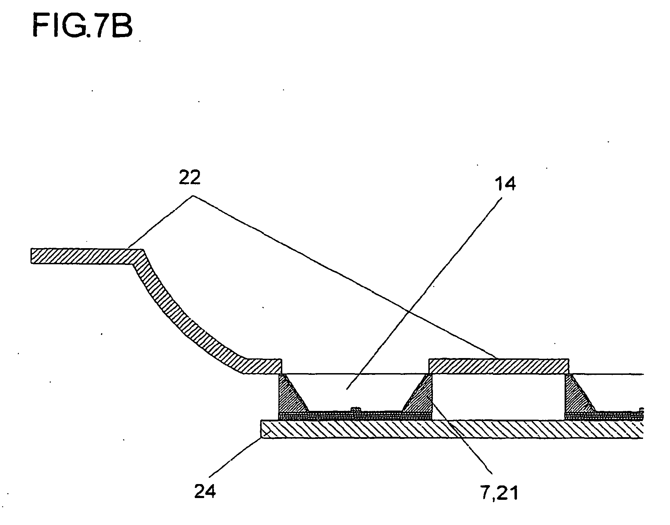

In the drawings referred to in connection with the embodiment and the first to third and fifth examples described above, the heat-conductive frame 7 and the metal frame 21 have no polarity; thus, even if they make contact with another electrically conductive member, there is no risk of electrical short-circuiting. Thus, as shown in a perspective view in Fig. 7A and in a sectional view in Fig. 7B, the heat-conductive frame 7 and the metal frame 21 can be fitted to a chassis 22. This permits the heat generated by the LED elements 11 to conduct, via the heat-conductive frame 7 and the metal frame 21, to the chassis 22, which is a larger heat-dissipating member. Thus, the heat is dissipated more efficiently to outside air.

In the drawings referred to in connection with the fifth example described above, the obverse-side electrodes 2 having a polarity which are formed on the circuit board 6 and the heat-conductive frame 7 are electrically and heat-conductively connected together; thus, the heat-conductive frame 7 has a polarity, and functions as an electrode for making the LED elements 11 emit light. In a case of mounting as a surface-mounting LED, the heat-conductive frame 7 can be used as a connection terminal on a board 24.

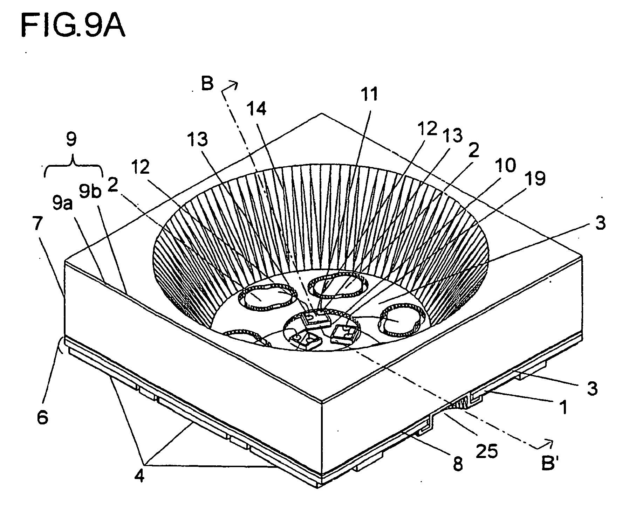

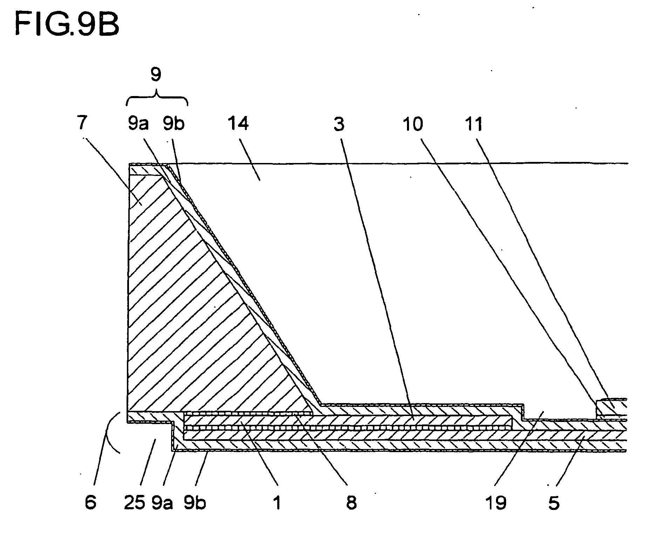

Figs. 9A and 9B show the electronic component mounting board of a sixth example, Fig. 9A being a perspective view, and Fig. 9B being a sectional view taken along line B-B' in Fig. 9A. In Fig. 9A, in the circuit board 6 described with reference to the drawings of the third example, a board opening 25 is formed; the heat-conductive frame 7 and the electrode 3 having no polarity are adhered together with an adhesive layer 8, and the heat-conductive frame 7 and the reverse-side electrode 5 having no polarity are heat-conductively connected together via a metal layer 9 formed in the board opening 25.

With the board opening 25 formed as shown in Figs. 9A and 9B, any conductor formed on the circuit board 6 can be heat-conductively connected to the heat-conductive frame 7 via the metal layer 9 formed in the board opening 25.

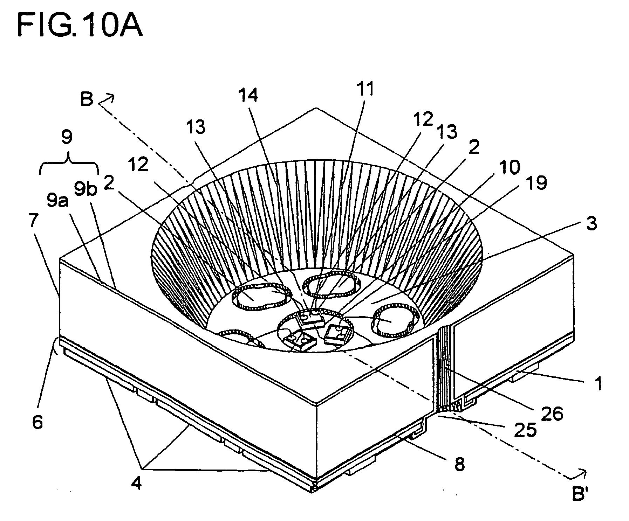

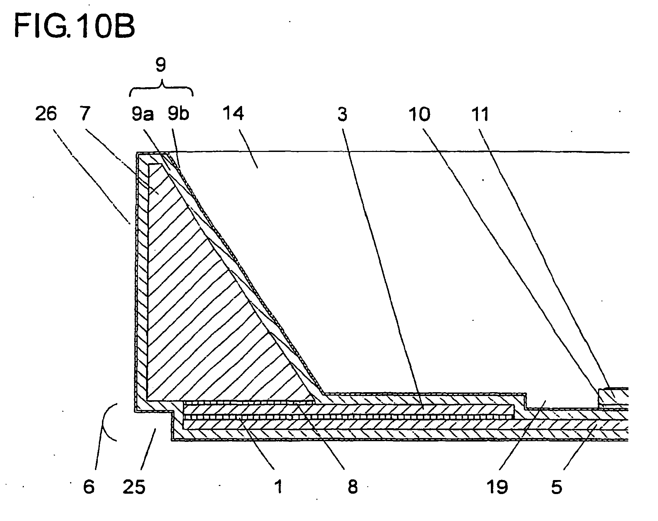

Figs. 10A and 10B show the electronic component mounting board of an eighth example of the invention, Fig. 10A being a perspective view, and Fig. 10B being a sectional view taken along line B-B' in Fig. 10A. As shown there, a frame opening 26 may be formed in the heat-conductive frame 7 on the board opening 25 shown in Figs. 9A and 9B of the sixth example so that the board opening 25 and the frame opening 26 are heat-conductively connected together.

Instead of the metal layer 9 formed in the board opening 25, an electrically conductive, heat-conductive metal member or metal paste may be used.

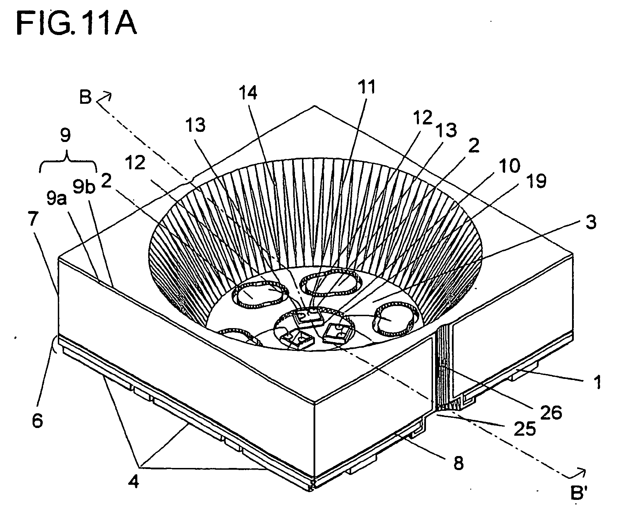

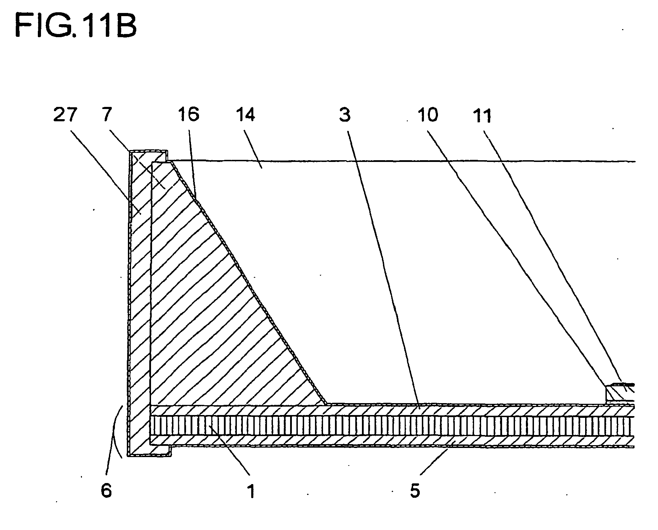

Figs. 1A and 11B show the electronic component mounting board of an eighth example, Fig. 11A being a perspective view, and Fig. 11B being a sectional view taken along line B-B' in Fig. 11A. As shown there, a heat-conductive frame 7 is fitted to an obverse-side electrode 3 having no polarity - the same as in the first example - on the circuit board 6 by use of a rivet 27 so that the heat-conductive frame 7 and the obverse-side electrode 3 are heat-conductively connected together (the reference sign 16 represents a metal surface-treatment layer).

In the structure shown in Figs. 11A and 11B, the heat-conductive frame 7 on the obverse-side electrode 3 is mechanically connected. This eliminates the need for an adhesive layer 8 as used in the first example, and eliminates the need to heat-conductively connect the heat-conductive frame 7 and the obverse-side electrode 3 by a metal layer 9; nevertheless it is still possible to obtain an effect similar to that obtained in the first example.

Moreover, the mechanical connection results in extremely high adhesion strength between the circuit board 6 and the heat-conductive frame 7 compared with that obtained in the structure of the first example.

Moreover, the use of the metal rivet 27 permits heat conduction from the reverse-side electrode 5 via the rivet 27 to the heat-conductive frame 7. Thus, even in a case where LED elements 11 are mounted on the reverse-side electrode 5, the heat generated by the LED elements 11 conducts from the reverse-side electrode 5 via the rivet 27 to the heat-conductive frame 7.

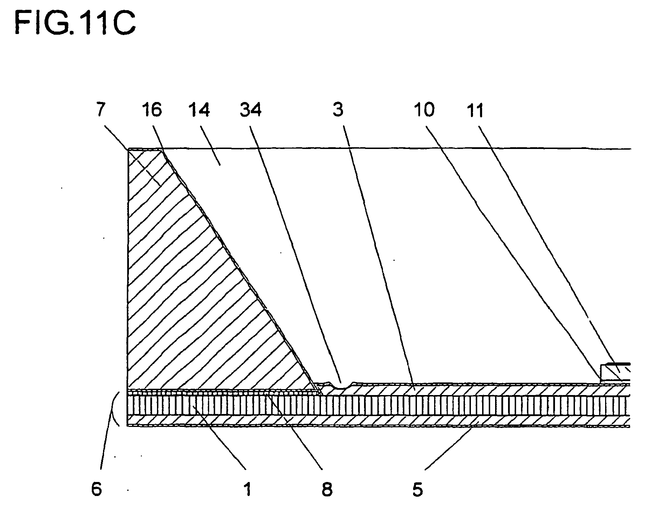

Fig. 11C is a sectional view showing another example of mechanically connecting the heat-conductive frame 7 on the obverse-side electrode 3. Here, a swaged portion 34 is formed in a circumferential portion of the obverse-side electrode 3 so that the obverse-side electrode 3 and the heat-conductive frame 7 are heat-conductively connected together. In a case where the swaged portion 34 provides the desired adhesion strength, the adhesive layer 8 may be omitted.

The mechanical connection here may instead be achieved by use of a bolt, by screwing in, or otherwise.

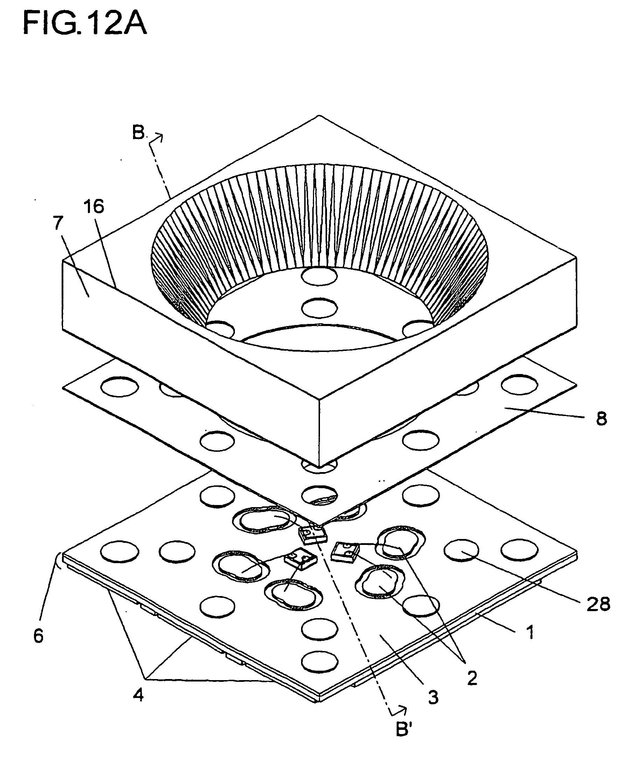

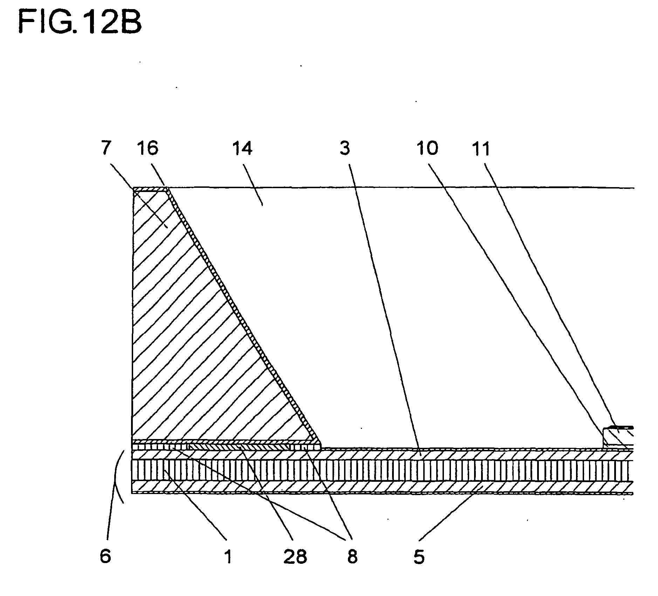

Figs. 12A and 12B show the electronic component mounting board of a second embodiment of the invention, Fig. 12A being an exploded view, and Fig. 12B being a sectional view taken along line B-B' in Fig. 12A. As shown there, electrically conductive projections 28 are formed on an obverse-side electrode 3 having no polarity which are formed on the circuit board 6, and an adhesive layer 8 is formed so as not to coat the top surface of the projections 28; then, a heat-conductive frame 7 is fitted and, as a result of the heat-conductive frame 7 making contact with and fixed to the top surface of the projections 28, the heat-conductive frame 7 and the obverse-side electrode 3 are electrically and heat-conductively connected together via the projections 28.

With the above structure, the heat generated by LED elements 11 is efficiently dissipated to outside air.

The electrically conductive projections 28 are formed, for example, as metal members of Ni, Au, Ag, Cu, Al, or the like; or are formed of an alloy such as solder; or are formed of a high-heat-conductivity material using an electrically conductive paste formed by mixing an electrically conductive material (metal such as Au, Ag, Cu, or Al, or an alloy such as solder, or a metal oxide such as ITO or SnO₂) with resin, carbon material, or the like.

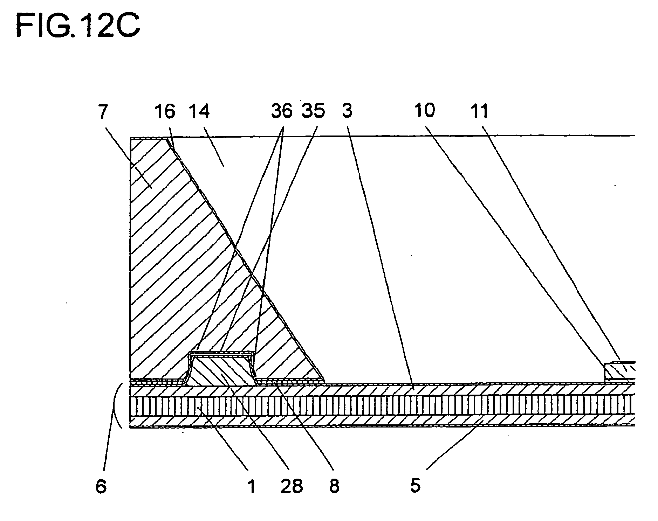

As shown in a sectional view in Fig. 12C, frame depressions 35 may be formed in the heat-conductive frame 7, in a circumferential or other part thereof, so that the projections 28 fit into the depressions 35 to achieve heat-conductive connection via contact portions 36. With this structure, in the process of bonding and fixing together the circuit board 6 and the heat-conductive frame 7 with the adhesive layer 8, the circuit board 6 and the heat-conductive frame 7 can be adhered together accurately.

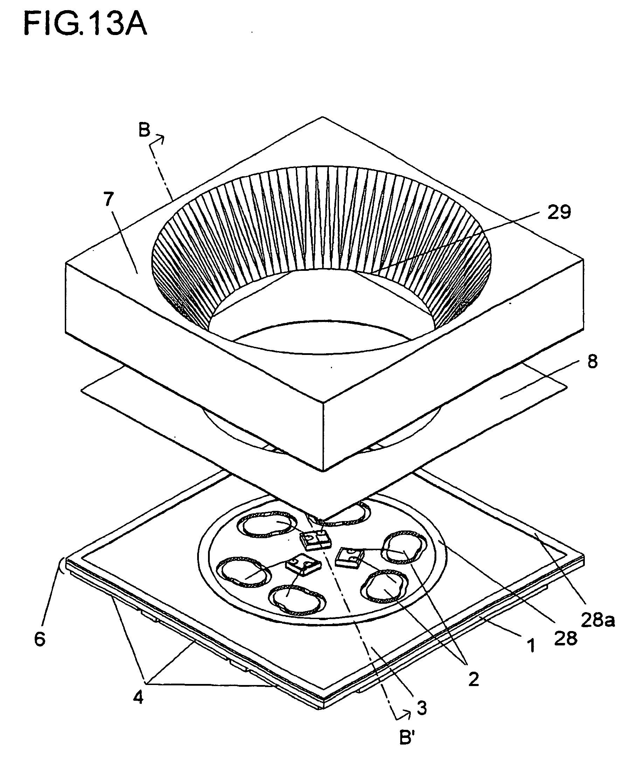

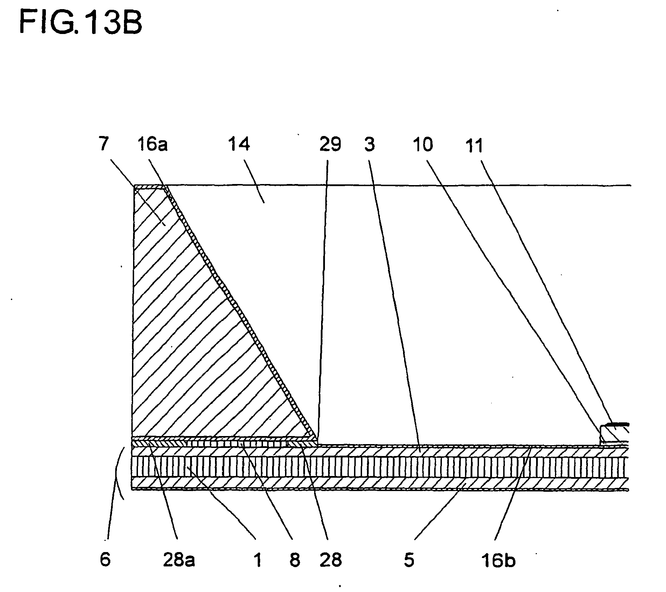

Figs. 13A and 13B show the electronic component mounting board of a third embodiment of the invention, Fig. 13A being an exploded view, and Fig. 13B being a sectional view taken along line B-B' in Fig. 13A. In Figs. 13A and 13B, an electrically conductive projection 28 is formed in a circular shape around a bottom opening 29 of a heat-conductive frame 7 (and the reference sign 28a represents an electrically conductive projection formed around the circumference).

As a result of this projection 28 being formed around the bottom opening 29 of the heat-conductive frame 7, the light emitted from LED elements 11 is shielded by the projection 28.

Moreover, the above projection 28 also offers an effect of, when the heat-conductive frame 7 and the circuit board 6 are adhered together with the adhesive layer 8, preventing the seeping out of the adhesive layer 8 during heat-crimping. It thus reduces contamination, resulting from the seeping out of the adhesive layer 8, of the areas where the LED elements 11 are mounted and of the obverse-side electrodes connected thereto, and also widens the control ranges of various conditions in the process, for example the condition for the thickness of the adhesive layer 8 and the conditions for heat-crimping for adhering the heat-conductive frame 7 and the circuit board 6 together. This leads to stable product quality and offers an effect of enhancing yields.

The shape of the electrically conductive projection 28 formed around the bottom opening 29 of the heat-conductive frame 7 is not limited to circular as shown in Figs. 13A and 13B; instead, an electrically conductive projection 28 having a rectangular or any other shape may be formed around the bottom opening 29.

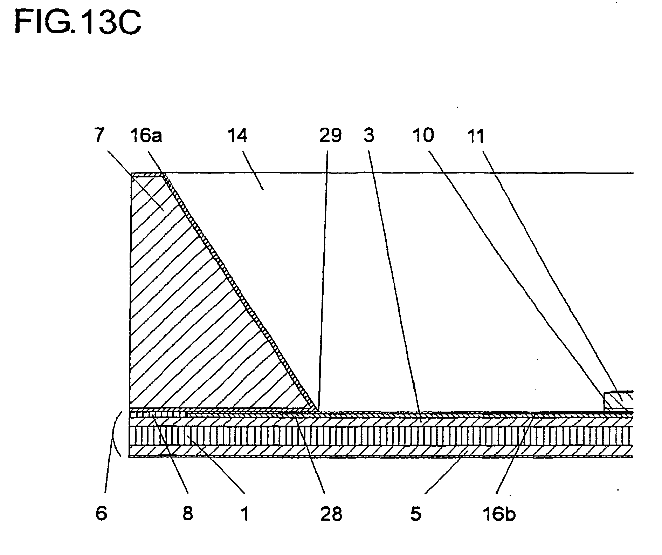

As shown in Fig. 13C, an electrically conductive projection 28 may be formed so as to close the bottom opening 29. In this case, the projection 28 is formed by electrolytic plating or electroless plating by use of metal such as Ni, Au, Ag, or Cu. Any electrode formed inside the bottom opening 29 is then coated with the metal formed by plating and thus comes to have an increased conductor volume. Thus, the heat generated by LED elements 11 more efficiently conducts to the heat-conductive frame 7.

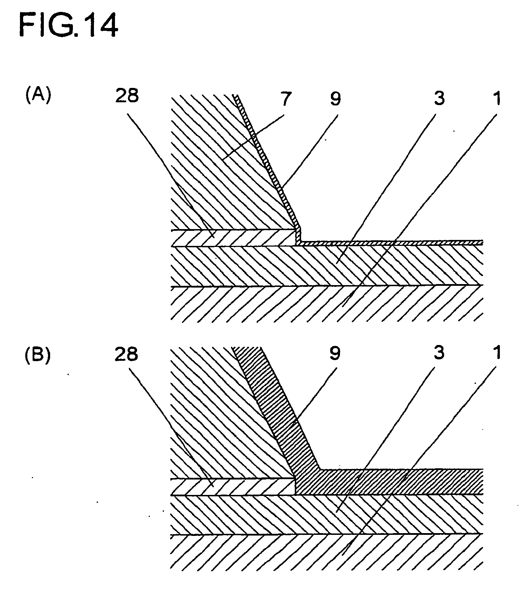

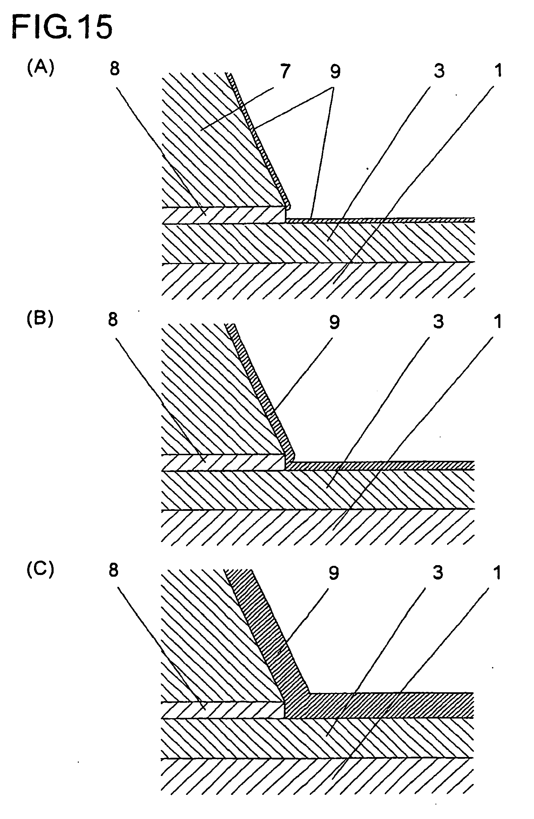

Fig. 14 shows a modified example of the third embodiment, and shows a structure in which a heat-conductive frame 7, an electrically conductive projection 28, and a conductor 3 (obverse-side electrode 3 having no polarity) are heat-conductively connected together by a metal layer 9. The metal layer 9 is typically formed by electrolytic plating. In Fig. 14(A), the metal layer 9 is deposited on the heat-conductive frame 7, on the electrically conductive projection 28, and on the obverse-side electrode 3 to form a continuous metal layer 9. In Fig. 14(B), the metal layer 9 is grown in the thickness direction thereof to achieve secure heat-conductive connection between the heat-conductive frame 7 and the obverse-side electrode 3. Fig. 15 is a diagram illustrating the process of forming the metal layer 9 of the first example by electrolytic plating.

With electric power fed to the heat-conductive frame 7 and to the obverse-side electrode 3 having no polarity (it may be fed to the obverse-side electrodes 2), as shown in Fig. 15(A), the metal layer 9 starts to grow from the heat-conductive frame 7 and from the obverse-side electrode 3; then, as shown in Fig. 15(B), the metal layer 9 coats the insulating adhesive layer 8; then, as shown in Fig. 15(C), the deposited metal layer 9 grows in the thickness direction thereof, and this achieves secure heat-conductive connection between the heat-conductive frame 7 and the obverse-side electrode 3. According to the example shown in Fig. 14, without relying on the metal layer 9 being formed integrally by growth of the metal layer 9 from the heat-conductive frame 7 and from the obverse-side electrode 3 as in the first example, it is possible to connect the heat-conductive frame 7, the projection 28, and the obverse-side electrode 3 together by the metal layer 9 formed on all of them. Thus, it is possible to obtain an effect of reducing the process time of electrolytic plating and a higher heat-dissipating effect.

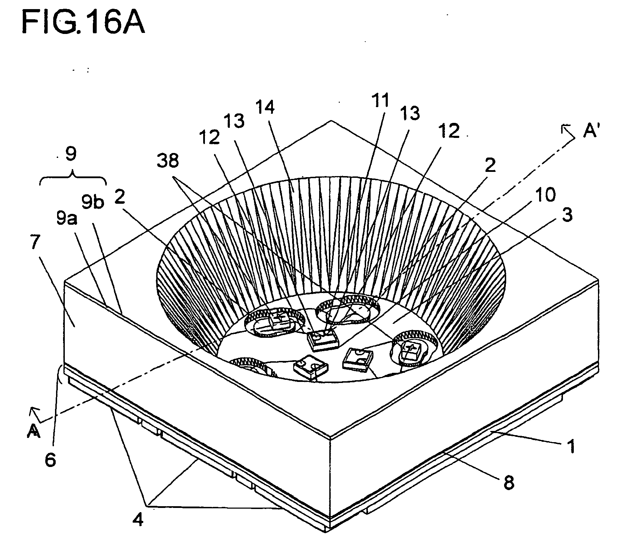

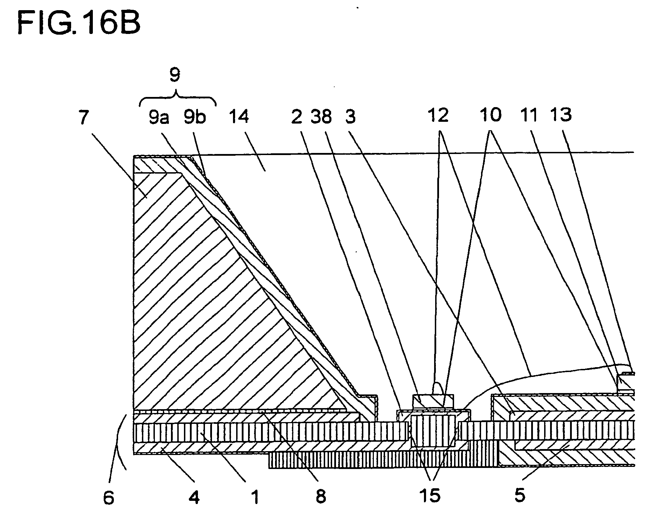

Figs. 16A and 16B show a modified example of the first example. Here, the metal layer 9 is not formed on the obverse-side electrodes 2 having a polarity which are not heat-conductively connected to the heat-conductive frame 7; thus, a step that is lower by the thickness of the metal layer 9 is formed and, there, Zener elements 38 are mounted on the obverse-side electrodes 2. Thus, the light emitted from the LED elements 11 is not shielded by the Zener elements 38, but efficiently shines the metal layer 9b on the heat-conductive frame 7 so as to exit upward efficiently. Moreover, the increased thickness of the metal layer 9 enhances heat dissipation.

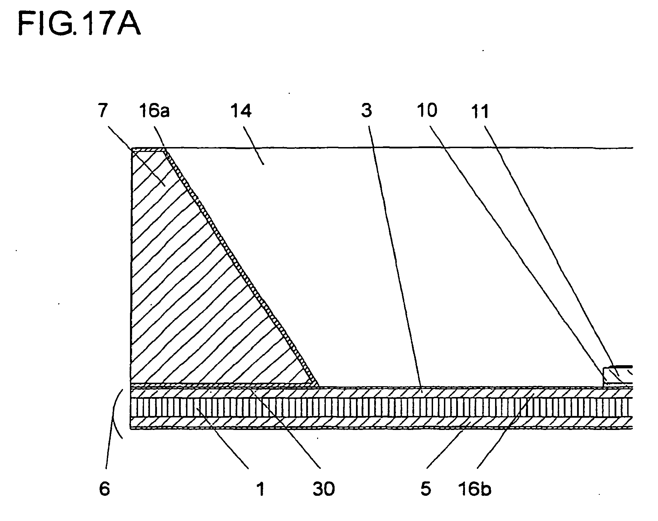

Fig. 17A is a sectional view of the electronic component mounting board of a ninth example. As shown there, the obverse-side electrode 3 having no polarity which is formed on the circuit board 6 of the first example and the heat-conductive frame 7 are welded together to form a metal diffusion layer 30, by which the metal surface-treatment layer 16 on the heat-conductive frame 7 and the obverse-side electrode 3 are heat-conductively connected together.

With this structure, there is no need for an adhesive layer 8 as in the first example, and there is no need for heat-conductive connection by a metal layer 9; nevertheless, it is possible to obtain an effect similar to that obtained in the first example.

Moreover, since the connection between the heat-conductive frame 7 and the obverse-side electrode 3 is achieved by the metallic bond provided by the metal diffusion layer 30, the adhesion strength between the circuit board 6 and the heat-conductive frame 7 is extremely high.

The connection by welding is achieved, for example, by welding using electric energy, such as arc welding or electron beam welding; or by welding using chemical energy, such as blazing including soldering; or by welding using mechanical energy, such as pressure welding; or by ultrasonic welding; or by laser welding.

Instead of the adhesive layer 8 shown in Figs. 13A and 13B of the third embodiment, solder may be used. The electrically conductive projection 28 formed around the bottom opening 29 of the heat-conductive frame 7 then offers an effect of a dam for preventing the flowing away of molten solder to electrodes.

The electrically conductive projection 28 formed around the bottom opening 29 of the heat-conductive frame 7 as described above may be replaced with an adhesive layer 8, with solder provided at a similar position; in this case, the heat-conductive frame 7 is then preliminarily fixed with the adhesive layer 8, then the solder is melted, and then the heat-conductive frame 7 and the obverse-side electrode 3 are welded together so that the heat-conductive frame 7 and the obverse-side electrode 3 are heat-conductively connected together (unillustrated).

The heat-conductive frame 7 and the obverse-side electrode 3 may be welded together totally or partly.

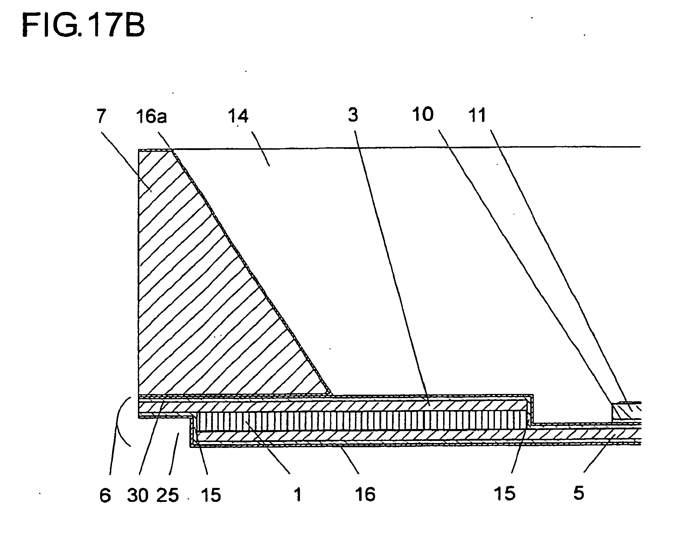

Fig. 17B is a sectional view of a modified example of the ninth example. As shown there, by use of a circuit board 6 having a board opening 25 closed with an obverse-side electrode 3 having no polarity, the part of the obverse-side electrode 3 having no polarity which closes the board opening 25 and a heat-conductive frame 7 may be heat-conductively connected together by being welded together partly by use of one of the welding methods mentioned above.

In a case where the projections 28 of the second embodiment are formed of metal such as Au, Ag, Cu, or Al or of an alloy such as solder, by use of one of the welding methods mentioned above, a metal diffusion layer 30 may be formed between the top surface of the projections 28 and the heat-conductive frame 7 so that these are joined together metallically. This increases the joint strength between the top surface of the projections 28 and the heat-conductive frame 7.

The various examples of electronic component mounting boards by way of which the invention has been specifically described above are in no way meant as any limitation. Preferably, the shape, inner wall angle, and height of the heat-conductive frame 7 or metal frame 21 are determined to suit the actual purpose; it is possible, for example, to give those frames a multiple-stage structure, or to form a heat-conductive frame 7 on the top surface of a metal frame 21 and heat-conductively connect them together.

In any other fashion, the features of the embodiments and the examples may be combined together appropriately to suit the actual purpose.

Now, examples of the method of fabricating an electronic component mounting board will be described.

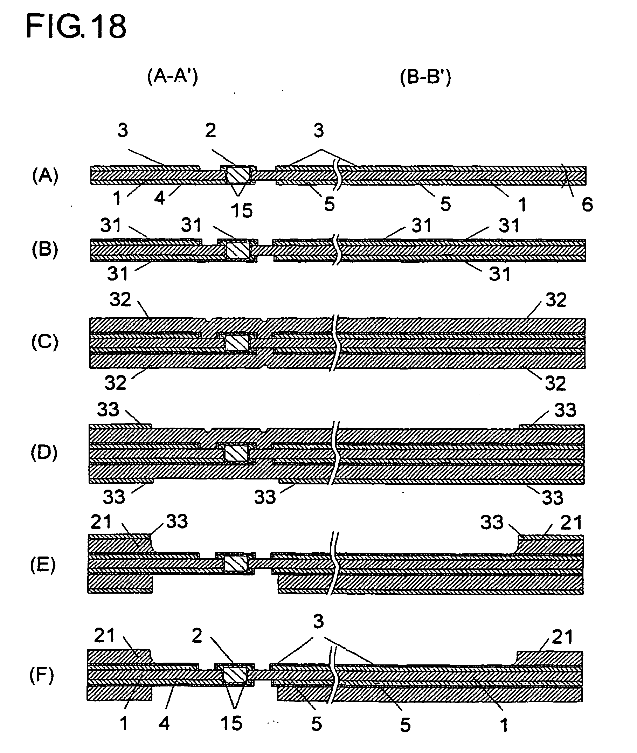

Fig. 18 shows different steps of the flow of a typical process for fabricating the electronic component mounting board having the structure of the fifth example, in the form of composite sectional views each consisting of part A-A', showing electrical connection, and part B-B', showing heat-conductive connection. In step 1, as shown in Fig. 18(A), a circuit board 6 is fabricated that has, formed on the top surface of an insulating base member 1, a plurality of conductors, namely an obverse-side electrode 2 having a polarity and an obverse-side electrode 3 having no polarity, and that has, formed on the bottom surface of the insulating base member 1 and electrically connected to the obverse-side electrodes respectively, a reverse-side electrode 4 having a polarity and a reverse-side electrode 5 having no polarity. In step 2, as shown in Fig. 18(B), a barrier metal layer 31 is formed so as to coat the entire surface of the electrodes formed on the circuit board 6. In step 3, as shown in Fig. 18(C), a plated-metal layer 32 is further formed over the entire surface including the barrier metal layer 31 by plating. In step 4, as shown in Fig. 18(D), as a mask layer for forming the frame and for forming the reverse-side electrodes, an etching resist layer 33 is formed on the plated-metal layer 32. In step 5, as shown in Fig. 18(E), by use of an etchant corrosive to the plated-metal layer 32 but not corrosive to the barrier metal layer 31, the plated-metal layer 32 is etched to form the metal frame 21 and the reverse-side electrodes. In step 6, as shown in Fig. 18(F), the etching resist layer 33 is removed.

Through the steps shown in Figs. 18(A) to 18(F), it is possible to fabricate the electronic component mounting board of the fifth example, which has an integral structure in which the metal frame 21 and the obverse-side electrode 3 are heat-conductively connected together.

It is preferable that the barrier metal layer 31 shown in Fig. 18(B) be formed of another metal that is non-corrodible (resistant to etching) during the etching of the plated-metal layer 32, such a metal being a solder alloy of Au, Ni, or Pb-Zn, or a Ni-Au alloy, or the like.

The barrier metal layer 31 is formed by electrolytic plating or electroless plating.

The plated-metal layer 32 is formed of Cu, and is formed by electrolytic plating or electroless plating.

In a case where the plated-metal layer 32 is formed of Cu and the barrier metal layer 31 is formed of one of the substances mentioned above, the etchant is an alkali etchant, a solution of ammonium persulfate, a mixed solution of hydrogen peroxide and sulfuric acid, or the like.

In a step after step 6 shown in Fig. 18(F), the barrier metal layer 31 partly exposed in the etching process and coating the electrodes may or may not be removed.

It is preferable that the electrodes and the metal frame 21 formed in the processes described above be plated with Cu, Ni, Au, Ag, Pd, or Sn, or a plurality of layers of any two or more of these metals laid together.

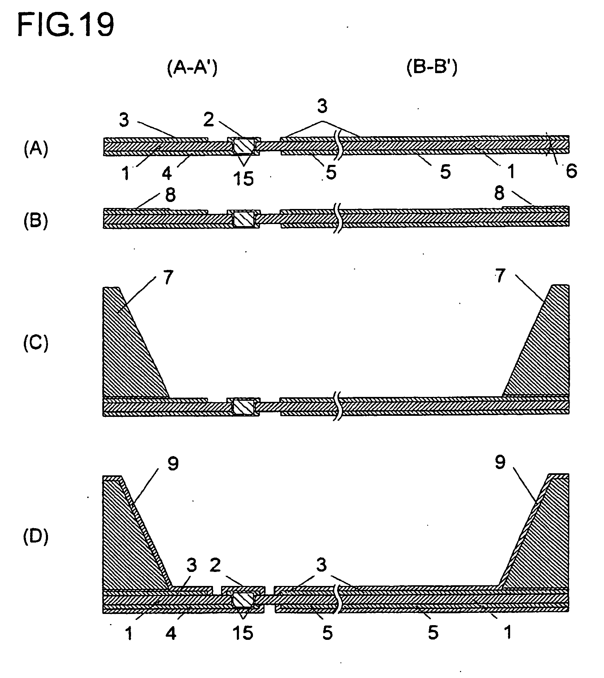

Fig. 19 shows different steps of the flow of a typical process for fabricating the electronic component mounting board having the structure of the first example, in the form of composite sectional views each consisting of part A-A', showing electrical connection, and part B-B', showing heat-conductive connection. In step 1, as shown in Fig. 19(A), a circuit board 6 is fabricated that has, formed on the top surface of an insulating base member 1, a plurality of conductors, namely an obverse-side electrode 2 having a polarity and an obverse-side electrode 3 having no polarity, and that has, formed on the bottom surface of the insulating base member 1 and electrically connected to the obverse-side electrodes respectively, a reverse-side electrode 4 having a polarity and a reverse-side electrode 5 having no polarity. In step 2, as shown in Fig. 19(B), an adhesive layer 8 is formed on the part of the obverse-side electrode 3 having no polarity where a heat-conductive frame 7 will be fitted. In step 3, as shown in Fig. 19(C), the heat-conductive frame 7 is fitted, with the adhesive layer 8, to the part of the obverse-side electrode 3 having no polarity where the heat-conductive frame 7 should be fitted. In step 4, as shown in Fig. 19(D), by electrolytic plating, a metal layer 9 is formed on the electrodes, on the heat-conductive frame 7, and on the exposed part of the adhesive layer 8 formed between the obverse-side electrode 3 having no polarity and the heat-conductive frame 7, so that the obverse-side electrode 3 having no polarity and the heat-conductive frame 7 are heat-conductively connected by the metal layer 9.

Through the steps shown in Figs. 19(A) to 19(D), it is possible to fabricate the electronic component mounting board of the first example, in which the heat-conductive frame 7 and the obverse-side electrode 3 are heat-conductively connected together.

In Fig. 19(B) showing step 2, the adhesive layer 8 is formed on the part of the obverse-side electrode 3 having no polarity where the heat-conductive frame 7 will be fitted; the adhesive layer 8 may instead be formed on a bottom part of the heat-conductive frame 7, or both on the obverse-side electrode 3 having no polarity and on a bottom part of the heat-conductive frame 7.

In a case where, as described above, the insulating base member 1 has a part where the heat-conductive frame 7 will be fitted, the adhesive layer 8 may be formed on the insulating base member 1, or on a bottom part of the heat-conductive frame 7, or both on the insulating base member 1 and on a bottom part of the heat-conductive frame 7.

In the examples described above, as shown in their respective diagrams, a single electronic component mounting board has been described separately; depending on product specifications, it is also possible to adopt a structure in which a plurality of such boards are coupled together.

The point is that the invention is applicable to any of the following structures: one in which a plurality of circuit boards 6 are coupled together and a plurality of heat-conductive frames 7, fitted thereto, are also coupled together; one in which a plurality of heat-conductive frames 7 are coupled together but circuit boards 6, fitted thereto, are separate from one another; and one in which heat-conductive frames 7 are separate from one another and circuit boards 6, fitted thereto, are also separate from one another.

The invention is also applicable to a structure in which, after LED elements 11 are mounted on a circuit board 6, sealing with resin 14 is applied, and then a heat-conductive frame 7 is fitted so that a conductor formed on the circuit board 6 and the heat-conductive frame 7 are heat-conductively connected together.

## Claims

1. An electronic component mounting board halving a heat-conductive frame (7) on a top surface of a circuit board (6) having a plurality of conductors (2, 3) formed thereon,
wherein the frame is heat-conductively connected to, among the plurality of conductors, a semiconductor element mount conductor (3) on which a semiconductor element (11) is to be mounted, and
wherein an adhesive layer (8) is formed between the frame and the semiconductor element mount conductor on the circuit board, **characterised in that** the adhesive layer (8) is formed such that, between the frame and the semiconductor element mount conductor on the circuit board, there is a region where the adhesive layer exists and a region where the adhesive layer does not exist and the frame and the semiconductor element mount conductor make contact with each other.

2. The electronic component mounting board according to claim 1,
wherein the frame (7) has no electrical polarity.

3. The electronic component mounting board according to claim 1,
wherein the frame (7) has one electrical polarity.

4. The electronic component mounting board according to claim 1,
wherein an opening (25) is formed in an end surface of the circuit board, and the semiconductor element mount conductor (3) is heat-conductively connected to a conductor (4) formed on a bottom surface of the circuit board, and
wherein the frame (7) and the conductor (4) formed on the bottom surface of the circuit board are heat-conductively connected together via a metal layer formed in the opening.

5. The electronic component mounting board according to claim 1,
wherein the frame (7) and the semiconductor element mount conductor (3) on the circuit board are heat-conductively connected together by being coated with a metal layer (16)

6. The electronic component mounting board according to claim 1, wherein the frame (7) and the semiconductor element mount conductor (3) on the circuit board are heat-conductively connected together by being mechanically connected.

7. The electronic component mounting board according to claim 1, wherein the frame (7) and the semiconductor element mount conductor (3) on the circuit board are heat-conductively connected together by being welded together.

8. The electronic component mounting board according to claim 1, wherein the frame (7) and the semiconductor element mount conductor (3) on the circuit board are heat-conductively connected together as a result of an electrically conductive projection (28) being formed on the frame or the semiconductor element mount conductor on the circuit board and the frame and the semiconductor element mount conductor on the circuit board being heat-conductively connected together via the projection.

9. The electronic projection (28) is mounting board according to claim 8, wherein the projection (28) is formed around a bottom opening (26) formed in the frame (7), or is formed so as to close the bottom opening formed in the frame.

10. The electronic component mounting board according to claim 1, wherein an LED element (11) is mounted on the semiconductor element mount conductor (3) on the circuit board.

## Patentansprüche

1. Montageplatte für elektronische Komponenten, die einen wärmeleitenden Rahmen (7) auf einer oberen Oberfläche einer Leiterplatte (6) aufweist, die eine Anzahl von darauf gebildeten Leitern (2, 3) aufweist,
wobei der Rahmen wärmeleitend mit, unter der Anzahl von Leitern, einem Halbleiterelementbefestigungsleiter (3) verbunden ist, auf dem ein Halbleiterelement (11) zu montieren ist, und
wobei eine Klebeschicht (8) zwischen dem Rahmen und dem Halbleiterelementbefestigungsleiter auf der Leiterplatte gebildet ist, **dadurch gekennzeichnet, dass** die Klebeschicht (8) so gebildet ist, dass es zwischen dem Rahmen und dem Halbleiterelementbefestigungsleiter auf der Leiterplatte einen Bereich gibt, wo die Klebeschicht vorhanden ist, und einen Bereich, wo die Klebeschicht nicht vorhanden ist und der Rahmen und der Halbleiterelementbefestigungsleiter Kontakt miteinander ausüben.

2. Montageplatte für elektronische Komponenten gemäß Anspruch 1, wobei der Rahmen (7) keine elektrische Polarität aufweist.

3. Montageplatte für elektronische Komponenten gemäß Anspruch 1, wobei der Rahmen (7) eine elektrische Polarität aufweist.

4. Montageplatte für elektronische Komponenten gemäß Anspruch 1, wobei eine Öffnung (25) in einer Endoberfläche der Leiterplatte gebildet ist und der Halbleiterelementbefestigungsleiter (3) wärmeleitend mit einem Leiter (4), der auf einer unteren Oberfläche der Leiterplatte gebildet ist, verbunden ist und
wobei der Rahmen (7) und der Leiter (4), der auf der unteren Oberfläche der Leiterplatte gebildet ist, mittels einer Metallschicht, die in der Öffnung gebildet ist, wärmeleitend miteinander verbunden sind.

5. Montageplatte für elektronische Komponenten gemäß Anspruch 1, wobei der Rahmen (7) und der Halbleiterelementbefestigungsleiter (3) auf der Leiterplatte wärmeleitend miteinander verbunden sind, indem sie mit einer Metallschicht (16) beschichtet sind.

6. Montageplatte für elektronische Komponenten gemäß Anspruch 1, wobei der Rahmen (7) und der Halbleiterelementbefestigungsleiter (3) auf der Leiterplatte wärmeleitend miteinander verbunden sind, indem sie mechanisch verbunden sind.

7. Montageplatte für elektronische Komponenten gemäß Anspruch 1, wobei der Rahmen (7) und der Halbleiterelementbefestigungsleiter (3) auf der Leiterplatte wärmeleitend miteinander verbunden sind, in dem sie zusammen verschweißt sind.

8. Montageplatte für elektronische Komponenten gemäß Anspruch 1, wobei der Rahmen (7) und der Halbleiterelementbefestigungsleiter (3) auf der Leiterplatte wärmeleitend miteinander verbunden sind als Ergebnis einer elektrisch leitenden Erhebung (28), die auf dem Rahmen oder dem Halbleiterelementbefestigungsleiter auf der Leiterplatte gebildet ist und wobei der Rahmen und der Halbleiterelementbefestigungsleiter auf der Leiterplatte mittels der Erhebung wärmeleitend miteinander verbunden sind.

9. Montageplatte für elektronische Komponenten gemäß Anspruch 8, wobei die Erhebung (28) um eine untere Öffnung (26) gebildet ist, die in dem Rahmen (7) gebildet ist, oder so gebildet ist, dass sie die untere Öffnung, die in dem Rahmen gebildet ist, schließt.

10. Montageplatte für elektronische Komponenten gemäß Anspruch 1, wobei ein LED-Element (11) auf dem Halbleiterelementbefestigungsleiter (3) auf der Leiterplatte befestigt ist.

## Revendications

1. Carte de montage de composant électronique comportant une structure thermiquement conductrice (7) sur une surface supérieure d'un circuit imprimé (6) sur lequel est formée une pluralité de conducteurs (2, 3) ;
dans laquelle la structure est raccordée de manière thermiquement conductrice, parmi la pluralité de conducteurs, à un conducteur de montage d'élément semi-conducteur (3) sur lequel un élément semi-conducteur (11) doit être monté, et
dans laquelle une couche adhésive (8) est formée entre la structure et le conducteur de montage d'élément semi-conducteur sur le circuit imprimé, **caractérisée en ce que** la couche adhésive (8) est formée de telle sorte que, entre la structure et le conducteur de montage d'élément semi-conducteur sur le circuit imprimé, il existe une zone dans laquelle la couche adhésive existe et une zone dans laquelle la couche adhésive n'existe pas et la structure et l'élément de montage d'élément semi-conducteur sont en contact l'un avec l'autre.

2. Carte de montage de composant électronique selon la revendication 1,
dans laquelle la structure (7) ne présente pas de polarité électrique.

3. Carte de montage de composant électronique selon la revendication 1,
dans laquelle la structure (7) présente une polarité électrique.

4. Carte de montage de composant électronique selon la revendication 1, dans laquelle une ouverture (25) est formée sur une surface d'extrémité du circuit imprimé, et le conducteur de montage d'élément semi-conducteur (3) est raccordé de manière thermiquement conductrice à un conducteur (4) formé sur une surface inférieure du circuit imprimé, et
dans laquelle la structure (7) et le conducteur (4) formés sur la surface inférieure du circuit imprimé sont raccordés ensemble de manière thermiquement conductrice par l'intermédiaire d'une couche métallique formée sur l'ouverture.

5. Carte de montage de composant électronique selon la revendication 1,
dans laquelle la structure (7) et le conducteur de montage d'élément semi-conducteur (3) sur le circuit imprimé sont raccordés ensemble de manière thermiquement conductrice par dépôt d'une couche métallique (16).

6. Carte de montage de composant électronique selon la revendication 1,
dans laquelle la structure (7) et le conducteur de montage d'élément semi-conducteur (3) sur le circuit imprimé sont raccordés ensemble de manière thermiquement conductrice par liaison mécaniquement.

7. Carte de montage de composant électronique selon la revendication 1,
dans laquelle la structure (7) et le conducteur de montage d'élément semi-conducteur (3) sur le circuit imprimé sont raccordés ensemble de manière thermiquement conductrice par soudage.

8. Carte de montage de composant électronique selon la revendication 1,
dans laquelle la structure (7) et le conducteur de montage d'élément semi-conducteur (3) sur le circuit imprimé sont raccordés ensemble de manière thermiquement conductrice en résultat d'une saillie électriquement conductrice (28) formée sur la structure ou sur le conducteur de montage d'élément semi-conducteur sur le circuit imprimé et la structure et le conducteur de montage d'élément semi-conducteur sur le circuit imprimé étant raccordés ensemble de manière thermiquement conductrice par l'intermédiaire de la saillie.

9. Carte de montage de composant électronique selon la revendication 8,
dans laquelle la saillie (28) est formée autour d'une ouverture inférieure (26) formée sur la structure (7), ou est formée de manière à fermer l'ouverture inférieure formée sur la structure.

10. Carte de montage de composant électronique selon la revendication 1,
dans laquelle un élément à diode LED (11) est monté sur le conducteur de montage d'élément semi-conducteur (3) sur le circuit imprimé.
